# EUROPEAN PATENT APPLICATION

(11) **EP 2 563 103 A1**
(43) Date of publication of application: **27.02.2013**
(21) Application number: 11856268.5
(22) Date of filing: 19.12.2011
(51) Int. Cl.: H05K 1/11, H01B 5/00, H05K 1/09, H05K 3/40, H05K 3/46

(54) **WIRING SUBSTRATE, METHOD FOR MANUFACTURING WIRING SUBSTRATE, AND VIA PASTE**

(30) Priority: 18.01.2011 JP 2011007935
(71) Applicant: Panasonic Corporation, Osaka 571-8501 (JP); Kyoto Elex Co., Ltd., Kyoto-shi Kyoto 601-8391 (JP)
(72) Inventor: HIRAI, Shogo, Osaka 540-6207 (JP); HIMORI, Tsuyoshi, Osaka 540-6207 (JP); ISHITOMI, Hiroyuki, Osaka 540-6207 (JP); HIGUCHI, Takayuki, Osaka 540-6207 (JP); TOMEKAWA, Satoru, Kyoto 601-8391 (JP); NAKAYAMA, Yutaka, Kyoto 601-8391 (JP)
(74) Representative: TBK
(86) International application number: PCT/JP2011/007070
(87) International publication number: WO 2012/098619

(57) **Abstract**

Disclosed is a multilayer wiring board having via-hole conductors, the via-hole conductor including a metal portion and a resin portion. The metal portion includes a first metal region which includes a link of copper particles forming a path electrically connecting a first wiring and a second wiring; a second metal region mainly composed of a metal selected from the group consisting of tin, a tin-copper alloy, and a tin-copper intermetallic compound; a third metal region mainly composed of bismuth; and a fourth metal region composed of tin-bismuth solder particles. The link has plane-to-plane contact portions where the copper particles are in plane-to-plane contact with one another. At least a part of the second metal region is in contact with the first metal region. The tin-bismuth solder particles, each surrounded by the resin portion, are interspersed in the via-hole conductor.

## Description

### [Technical Field]

The present invention relates to a wiring board, a production method of a wiring board, and a via paste. Specifically, the present invention relates to achieving low resistance and enhancing connection reliability of via-hole conductors.

### [Background Art]

A conventionally-known multilayer wiring board is obtained by creating an interlayer connection between two wirings formed three-dimensionally on an insulating resin layer. Known as a way to create such an interlayer connection, is use of via-hole conductors which are formed by filling holes created in the insulating resin layer, with a conductive paste. Also known are via-hole conductors which are formed by filling with metal particles containing copper (Cu), in place of a conductive paste, and then fixing the metal particles to one another with use of an intermetallic compound.

Specifically, for example, Patent Literature 1 below discloses via-hole conductors having a matrix-domain structure, in which domains of Cu particles are interspersed throughout a CuSn com pound matrix.

Also, for example, Patent Literature 2 below discloses a sinterable composition for use in forming via-hole conductors, the composition including: a high-melting-point particle-phase material that includes Cu; and a low-melting-point material selected from metals such as tin (Sn) and tin alloys. The above sinterable composition is sintered in the presence of a liquid phase or a transient liquid phase.

Also, for example, Patent Literature 3 below discloses a via-hole conductor material in which an alloy layer with a solidus temperature of 250°C or higher is formed around the outer surface of copper particles, by heating a conductive paste containing tin-bismuth (Sn-Bi) metal particles and copper particles at a temperature equal to or higher than the melting point of the Sn-Bi metal particles. Such a via-hole conductor material is described as achieving high connection reliability, since interlayer connection is created by the alloy layers with a solidus temperature of 250°C or higher being joined to one another, thus preventing the alloy layers from melting even during heat cycling tests and reflow resistance tests.

Also, for example, Patent Literature 4 below discloses a multilayer wiring board including via-hole conductors each including: 80 to 97 wt% of copper and tin, in total; and 3 to 20 wt% of bismuth.

### [Citation List]

### [Patent Literatures]

[Patent Literature 1] Japanese Laid-Open Patent Publication No. 2000-49460
[Patent Literature 2] Japanese Laid-Open Patent Publication No. Hei 10-7933
[Patent Literature 3] Japanese Laid-Open Patent Publication No. 2002-94242
[Patent Literature 4] Japanese Laid-Open Patent Publication No. 2002-290052

### [Summary of Invention]

### [Technical Problem]

The via-hole conductor disclosed in Patent Literature 1 will be described in detail, with reference to Fig. 22. Fig. 22 is a schematic sectional view of the portion where a wiring 1 and a via-hole conductor 2 are connected to each other, in the multilayer wiring board disclosed in Patent Literature 1.

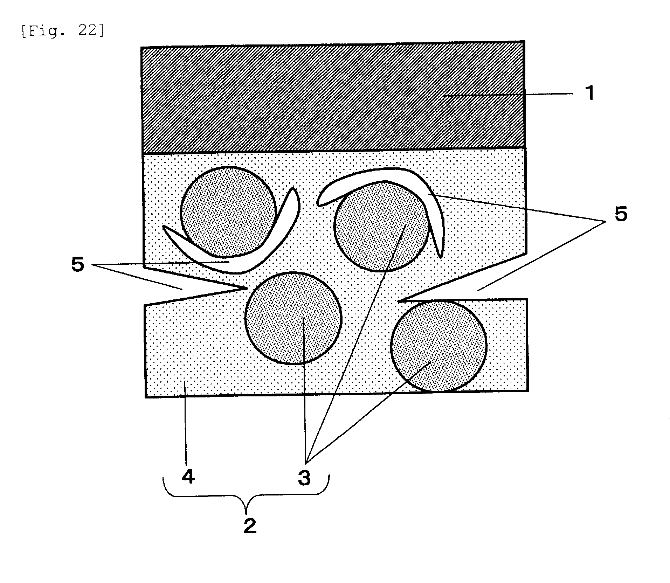

In the schematic sectional view of Fig. 22, the via-hole conductor 2 is in contact with the wiring 1 formed on the multilayer wiring board surface. The via-hole conductor 2 comprises: a matrix including an intermetallic compound 4 such as Cu₃Sn or Cu₆Sn₅; and copper-containing powder 3 interspersed as domains throughout the matrix including the intermetallic compound 4. In the via-hole conductor 2, the matrix-domain structure is formed by controlling the weight ratio represented by Sn/(Cu + Sn) to be in the range of 0.25 to 0.75. However, the above via-hole conductor 2 has the problem of being prone to voids or cracks (Ref. No. 5 in Fig. 22) during thermal shock tests.

The above voids or cracks are caused by a CuSn compound such as Cu₃Sn or Cu₆Sn₅ produced due to Cu diffusing into Sn-Bi metal particles when the via-hole conductor 2 is exposed to heat, during, for example, thermal shock tests or reflow processing. The above voids are also caused by internal stress generated inside the via-hole conductor 2, due to Cu₃Sn, which is an intermetallic compound of Cu and Sn included in Cu-Sn diffusion-bonded joints formed at the Cu/Sn interface, changing to Cu₆Sn₅ by heating performed during various reliability tests.

Also, the sinterable composition disclosed in Patent Literature 2 is sintered in the presence or absence of a transient liquid phase, that is generated, for example, during hot pressing performed to laminate prepregs. Use of the above sinterable composition would prove difficult to achieve Pb-free products as demanded by the market, since it includes Cu, Sn, and lead (Pb). It is also difficult to apply the above sinterable composition to a typical insulating resin layer that is obtained by impregnating glass fibers with epoxy resin (this may also be called a glass/epoxy resin layer), since it reaches a high temperature from 180°C to 325°C during hot pressing.

Also, in the via-hole conductor material disclosed in Patent Literature 3, the alloy layer formed on the surface of the Cu particles has high resistance. Therefore, there is the problem of higher resistance compared to connection resistance obtained only by contact among Cu particles or among Ag particles as in a typical conductive paste containing Cu particles, silver (Ag) powder, or the like.

In the via-hole conductor disclosed in Patent Literature 4 as well, the alloy layer formed on the surface of the Cu particles has high resistance. Therefore, there is the problem of not being able to obtain an interlayer connection with a sufficiently low resistance. This will be described later.

An object of the present invention is to provide a multilayer wiring board which includes low-resistance via-hole conductors with high connection reliability, the via-hole conductors serving as an interlayer connection between two wirings formed three-dimensionally on an insulating layer; and which is capable of meeting the need for being lead-free.

### [Solution to Problem]

One aspect of the present invention is directed to a wiring board comprising:
at least one insulating resin layer;
a first wiring disposed on a first surface of the insulating resin layer;
a second wiring disposed on a second surface of the insulating resin layer; and
via-hole conductors provided in a manner such that they penetrate through the insulating resin layer and electrically connect the first wiring and the second wiring,
wherein the via-hole conductor comprises a metal portion and a resin portion,
the metal portion comprising:
   a first metal region including a link of copper particles which serves as a path for electrically connecting the first wiring and the second wiring;
   a second metal region mainly composed of at least one metal selected from the group consisting of tin, a tin-copper alloy, and a tin-copper intermetallic compound;
   a third metal region mainly composed of bismuth and in contact with the second metal region; and
   a fourth metal region composed of tin-bismuth solder particles,
the copper particles forming the link are in plane-to-plane contact with one another, thereby forming plane-to-plane contact portions,
at least a part of the second metal region is in contact with the first metal region, and
the tin-bismuth solder particles, each surrounded by the resin portion, are interspersed in the via-hole conductor.

Another aspect of the present invention is directed to a method for producing a wiring board, the method comprising:
a first step of covering a surface of an insulating resin sheet with a protective film;
a second step of perforating the insulating resin sheet having the protective film thereon, so as to create through-holes;
a third step of filling the through-holes with a via paste containing copper particles, tin-bismuth solder particles, and a thermally curable resin, in which the content of the copper particles is in the range of 30 to 90 mass%; and the weight ratio between copper (Cu) of the copper particles and tin (Sn) of the tin-bismuth solder particles, represented by Cu/Sn, is in the range of 1.59 to 21.43;
a fourth step of removing the protective film after the third step to reveal protrusions each formed by a part of the via paste protruding from the through-hole;
a fifth step of disposing metal foil on at least one surface of the insulating resin sheet in a manner such that it covers the protrusions;
a sixth step of compression bonding the metal foil onto the at least one surface of the insulating resin sheet, and compressing, at a temperature lower than the eutectic temperature of the tin-bismuth solder particles, the via paste by way of the protrusions, so as to form a link of the copper particles, the link having plane-to-plane contact portions where the copper particles are in plane-to-plane contact with one another; and
a seventh step of heating after the sixth step, the via paste at a temperature higher than the eutectic temperature of the tin-bismuth solder particles,
wherein, in the sixth and seventh steps, a part of the tin-bismuth solder particles, each surrounded by the resin portion, are interspersed in the via-hole conductor.
Still another aspect of the present invention is directed to a via paste used to form the above wiring board,
wherein the via paste contains copper particles, tin-bismuth solder particles, and a thermally curable resin,
the content of the copper particles is in the range of 30 to 90 mass%, and
the weight ratio between copper (Cu) of the copper particles and tin (Sn) of the tin-bismuth solder particles, represented by Cu/Sn, is in the range of 1.59 to 21.43.

The object, features, aspects, and advantages of the present invention will become more apparent by referring to the following detailed description and accompanying drawings.

### [Advantageous Effects of Invention]

According to the present invention, by the link of the copper particles having the plane-to-plane contact portions, that is, the link formed by plane-to-plane contact created among the copper particles included in the via-hole conductor formed in the wiring board, low-resistance conductive paths are formed, and thus, low-resistance interlayer connections are achieved. Furthermore, the tin-bismuth solder particles each surrounded by the resin portion, are interspersed in the via-hole conductor in a manner such that they are present in the area surrounding the link of the copper particles; the first metal region including the link; the second metal region; or the third metal region in contact with the second metal region. Thus, the reliability of the metal portion is enhanced.

### [Brief Description of Drawings]

Fig. 1A is a schematic sectional view of a multilayer wiring board 11 in a first embodiment.
Fig. 1B is an enlarged schematic sectional view showing the vicinity of a via-hole conductor 14 in Fig. 1A.
Fig. 2 is an explanatory drawing describing, with respect to the first embodiment, a link 17a of copper particles 7 serving as a conductive path 23 between copper wirings 12, the link 17a being formed by the copper particles 7 coming into plane-to-plane contact with one another.
Fig. 3 is a schematic sectional view of the via-hole conductor when Cu/Sn is smaller than 1.59.
Fig. 4 is a sectional view of a step, describing one example of a method for producing the multilayer wiring board 11 in the first embodiment.
Fig. 5 illustrates a step subsequent to Fig. 4, describing one example of a method for producing the multilayer wiring board 11.
Fig. 6 illustrates a step subsequent to Fig. 5, describing one example of a method for producing the multilayer wiring board 11.
Fig. 7 is a schematic sectional view describing, with respect to the first embodiment, the state at the time of compressing a via paste 28 filled in a through-hole in a resin sheet 25.
Fig. 8A is a schematic sectional view of a multilayer wiring board 111 in a second embodiment.
Fig. 8B is an enlarged schematic sectional view showing the vicinity of a via-hole conductor 14 in Fig. 8A.
Fig. 9 is a sectional view of a step, describing one example of a method for producing the multilayer wiring board 111.
Fig. 10 illustrates a step subsequent to Fig. 9, describing one example of a method for producing the multilayer wiring board 111.
Fig. 11 illustrates a step subsequent to Fig. 10, describing one example of a method for producing the multilayer wiring board 111.
Fig. 12 is a schematic sectional view describing, with respect to the second embodiment, the state at the time of compressing a via paste 28 filled in a through-hole 27 in a prepreg 125.
Fig. 13 is a graph showing resistance values (1 via/mΩ) relative to Cu/Sn weight ratios, of via-hole conductors obtained in Example 1.
Fig. 14A is a scanning electron microscope (SEM) image at 3000-times magnification, of a vertical section of a via conductor in a multilayer wiring board, obtained in the Example.
Fig. 14B is a tracing of Fig. 14A.
Fig. 15A is a SEM image at 6000-times magnification, of the vertical section of the via-hole conductor in a multilayer wiring board, obtained in Example 1.
Fig. 15B is a tracing of Fig. 15A.
Fig. 16A is a SEM image of a vertical section of a via-hole conductor in a multilayer wiring board, obtained in Example 1.
Fig. 16B is a tracing of Fig. 16A.
Fig. 17A is an image showing an elemental map of Cu in the SEM image of Fig. 16.
Fig. 17B is a tracing of Fig. 17A.
Fig. 18A is an image showing an elemental map of Sn in the SEM image of Fig. 16.
Fig. 18B is a tracing of Fig. 18A.
Fig. 19A is an image showing an elemental map of Bi in the SEM image of Fig. 16.
Fig. 19B is a tracing of Fig. 19A.
Fig. 20 is a graph showing a comparison of resistance values, between: via-hole conductors obtained from conventionally-known conductive pastes described in Patent Literature 4; and the via-hole conductor according to the present invention.
Fig. 21A is a SEM image at 3000-times magnification, of a vertical section of a via-hole conductor in a multilayer wiring board, obtained in Example 2.
Fig. 21B is a tracing of Fig. 21A.
Fig. 22 is a schematic sectional view describing a vertical section of a conventional via conductor.

### [Description of Embodiments]

### [First Embodiment]

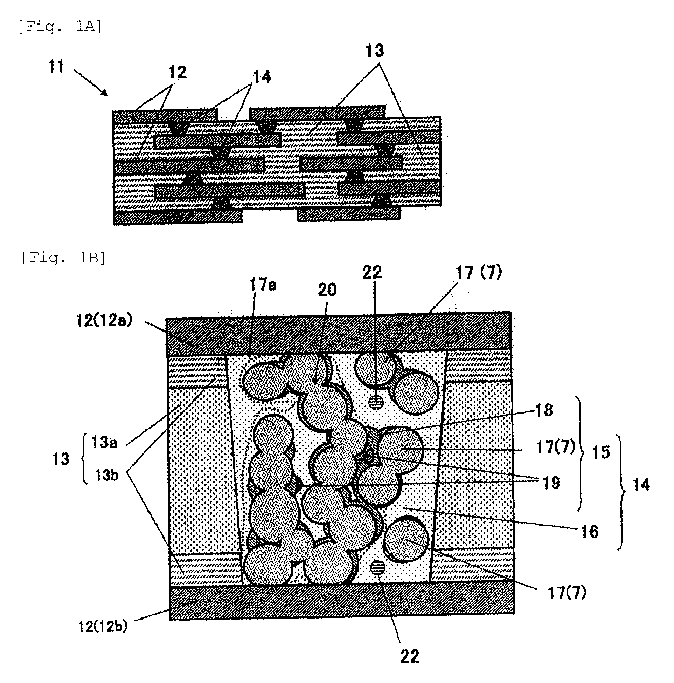

Fig. 1A is a schematic sectional view of a multilayer wiring board 11 having via-hole conductors 14 of the present embodiment. Also, Fig. 1B is an enlarged schematic view showing the vicinity of the via-hole conductor 14 in the multilayer wiring board of Fig. 1A.

As illustrated in Fig. 1A, in a multilayer wiring board 11, wirings 12 formed of metal foil such as copper foil, are electrically connected to one another by via-hole conductors 14 serving as interlayer connections. The wirings 12 are formed three-dimensionally on insulating resin layers 13, and the via hole conductors 14 penetrate through the insulating resin layers 13.

Fig. 1B is an enlarged schematic sectional view showing the vicinity of the via-hole conductor 14. In Fig. 1B, Ref. No. 12 (12a, 12b) denotes the wirings, Ref. No. 13 denotes the insulating resin layer, and Ref. No. 14 denotes the via-hole conductor. The via-hole conductor 14 comprises a metal portion 15 and a resin portion 16. Examples of the insulating resin layer 13 include, but are not particularly limited to, conventionally-known insulating layers used in multilayer wiring boards. In the present embodiment, a heat-resistant resin sheet, which is a laminate made of a heat-resistant resin sheet 13a with a cured resin layer laminated on both surfaces thereof, is used. The metal portion 15 comprises: first metal regions 17 formed from Cu particles 7; second metal regions 18 mainly composed of at least one metal selected from the group consisting of tin, a tin-copper alloy, and a tin-copper intermetallic compound; and third metal regions 19 mainly composed of Bi. Furthermore, it comprises fourth metal regions 22 composed of non-reactive tin-bismuth solder particles. The tin-bismuth solder particles serving as the fourth metal regions 22 are each surrounded by the resin portion 16 and are interspersed in the via-hole conductor 14. At least a part of the Cu particles 7 forms links 17a thereof in the area indicated by a dotted line, by being in contact with and thus linked to one another via plane-to-plane contact portions 20 where the Cu particles directly come into plane-to-plane contact with one another. The links 17a serve as low-resistance conductive paths which electrically connect the upper wiring 12a and the lower wiring 12b.

The average particle size of the Cu particles 7 is preferably 0.1 to 20 µm and further preferably 1 to 10 µm. When the average particle size of the Cu particles 7 is too small, in the via-hole conductor 14, there tends to be difficulty in forming the plane-to-plane contact portions as will be described later; and there also tends to be higher conductive resistance due to increased contact points among the particles. In contrast, when the average particle size of the Cu particles 7 is too large, there tends to be higher conductive resistance due to difficulty in increasing the filling rate when forming the via-hole conductors 14 with a small diameter, such as 30 to 150 µmØ. Particularly, in the case of the via-hole conductor being extremely small with a maximum diameter of 30 to to 150 µmØ, the average particle size of the copper particles is preferably 3 to 10 µm.

Purity of the Cu particles 7 is preferably 90 mass% or higher and further preferably 99 mass% or higher. The higher the purity, the softer the Cu particles 7 become. Thus, in a pressurization step that will be described later, the Cu particles 7 are easily pressed against one another, thereby ensuring increased area of contact among the Cu particles 7 due to the Cu particles 7 easily deforming when coming into contact with one another. Higher purity is also preferable in terms of enabling lower resistance of the Cu particle 7.

Herein, plane-to-plane contact between the copper particles, is not a state where the copper particles are in contact with each other to the extent of merely touching each other, but is a state where the adjacent copper particles are in contact with each other at their respective surfaces due to being pressurized and compressed and thus plastically deformed, resulting in increased contact therebetween. As such, by the copper particles becoming plastically deformed and thus adhered to each other, the plane-to-plane contact portion therebetween are maintained even after release of compressive stress.

The average particle size of the Cu particles 7, and also, the plane-to-plane contact portions 20 where the Cu particles 7 come into plane-to-plane contact with one another, are identified and measured by observing a sample with use of a scanning electron microscope (SEM). The sample is created by embedding a formed multilayer wiring board in resin and then polishing a vertical section of the via-hole conductor 14. Microfabrication means such as focused ion beam may also be used as necessary.

The Cu particles 7 come into contact with one another to form the links 17a, thereby forming low-resistance conductive paths between the wiring 12a and the wiring 12b. By forming the above links 17a, it is possible to reduce connection resistance between the wiring 12a and the wiring 12b.

Also, in the via-hole conductor 14, it is preferable that the links 17a with low resistance are formed to have a complicated network, by allowing the Cu particles to be in random contact with one another as illustrated in Fig. 1B, rather than in orderly arrangement. Formation of the above network by the links 17a enables a more reliable electrical connection. It is also preferable that the Cu particles 7 are in plane-to-plane contact with one another at random positions. By allowing the Cu particles 7 to be in plane-to-plane contact with one another at random positions, the resulting deformation of the particles enables dispersion of stress caused within the via-hole conductor 14 at times of exposure to heat, as well as dispersion of external force that is applied from the outside.

The proportion of the Cu particles 7 included in the via-hole conductor 14 is preferably 20 to 90 mass% and further preferably 40 to 70 mass%. When the proportion of the Cu particles 7 is too small, the links 17a formed of the Cu particles 7 in plane-to-plane contact with one another, are prone to become less reliable as conductive paths to provide electrical connection; and when too large, the resistance value is prone to fluctuate during reliability tests.

As illustrated in Fig. 1B, at least a part of the second metal region 18 mainly composed of at least one metal selected from the group consisting of tin, a tin-copper alloy, and a tin-copper intermetallic compound, is formed so that it is in contact with the surface of the first metal region 17. By forming the second metal region 18 in the above manner, that is, on the surface of the first metal region 17, the first metal region 17 is strengthened. Also, at least a part of the second metal region 18 preferably extends astride the plane-to-plane contact portion 20 where the copper particles 7 are in plane-to-plane contact with each other. By forming the second metal region 18 in the above manner such that it extends astride the plane-to-plane contact portion 20, connection by the plane-to-plane contact portion is further strengthened.

The second metal regions 18 are mainly composed of at least one metal selected from the group consisting of tin, a tin-copper alloy, and a tin-copper intermetallic compound. Specifically, for example, they are mainly composed of a simple substance of Sn, Cu₆Sn₅, Cu₃Sn, or the like. Also, for the remainder, other metals such as Bi and Cu may be included to the extent of not ruining the effect of the present invention, that is, specifically in the range of, for example, 10 mass% or less.

Also, as illustrated in Fig. 1B, in the metal portion 15, the third metal regions 19 mainly composed of Bi are preferably present in a manner such that they are not in contact with the Cu particles 7, but are in contact with the second metal regions 18. In the via-hole conductor 14, the third metal regions 19 not in contact with the Cu particles 7 do not reduce conductivity of the first metal regions 17.

The third metal regions 19 are mainly composed of Bi. Also, for the remainder, an alloy, intermetallic compound, or the like, of Bi and Sn, may be included to the extent of not ruining the effect of the present invention, that is, specifically in the range of, for example, 20 mass% or less.

Since the second metal regions 18 and the third metal regions 19 are in contact with one another, they normally include both Bi and Sn. In this case, the second metal regions 18 have a higher Sn concentration than the third metal regions 19, while the third metal regions 19 have a higher Bi concentration than the second metal regions 18. In addition, it is preferred that the interface between the second metal region 18 and the third metal region 19 is not definite than being definite. When the interface is not definite, it is possible to prevent stress from concentrating at the interface even under heating conditions for thermal shock tests or the like.

Also, the fourth metal regions 22 composed of tin-bismuth solder particles, each surrounded by the resin portion 16, are interspersed in the via-hole conductor 14. The tin-bismuth solder particles serving as the fourth metal regions are non-reactive tin-bismuth solder particles that do not react with other components in a production step that will be described later. The above tin-bismuth solder particles, each surrounded by the resin portion 16, are interspersed in the via-hole conductor 14, so that they do not come into contact with the link of the copper particles, thus not obstructing the formation of the conductive path.

As above, by having the non-reactive tin-bismuth solder particles interspersed among the first metal regions including the link of the copper particles, the second metal regions, or the third metal regions in contact with the second region, it is possible to improve oxidation resistance of the metal portion in the via-hole conductor, that is, of the first, second, and third metal regions in the via-hole conductor, or, to reduce adverse effects caused by moisture or the like that remains inside or enters into the wiring board.

Also, it is possible to improve oxidation resistance of the first metal region including the link of the copper particles, of the second metal region, or of the third metal region in contact with the second region; or to reduce the effects caused by moisture, etc. that remain inside the wiring board or enter into the wiring board while in use, by, as above, having a part of the tin-bismuth solder particles interspersed, as a kind of catchers (or as sacrificial matters), in the via-hole conductor. That is, a part of the tin-bismuth solder particles serves as a part of the metal portion which contributes to electrical conductivity of the via-hole conductor, more specifically, electrical conductivity between the wiring boards, by being covered with resin and thus being electrically insulated.

It is presumed that the effects caused by moisture, etc. as above can be reduced, due to a part of the tin-bismuth solder particles being able to suppress such effects in the following manner. The tin-bismuth solder particles are interspersed among the metallic materials which compose the via-hole conductor, the particles having a clean (or reduced) surface due to being interspersed in the resin and thus reduced by a functional group such as an amine group or a hydroxyl group contained in the resin. Thus, the tin-bismuth solder particles serve as traps (catchers, or sacrificial materials) against moisture slightly remaining inside the wiring board (or entering from the outside) and against oxidants, during downstream processing for producing the wiring board, during use of the wiring board product by a customer, and the like. As such, a part of the tin-bismuth solder particles can suppress the effects caused by moisture and by oxidation.

To suppress the effects of moisture and of oxidation as above, the tin-bismuth solder particles interspersed in the via-hole conductor preferably have an average particle size that is equal to or smaller than the average particle size of the copper particles. This is because, even if the tin-bismuth solder particles having a larger average particle size than the copper particles are interspersed in the resin, it may not be possible for the tin-bismuth solder particles to have a specific surface area sufficient for them to serve as traps or the like; or to be uniformly distributed.

For the above purpose, it is effective to make the tin-bismuth solder particles in a via paste (particularly a liquid via paste during formation of the via-hole conductor, prior to steps of compressing, heating, etc.) have an average particle size that is equal to or smaller than the average particle size of the copper particles contained in the liquid via paste, depending on the purpose of use (e.g., for further enhancing reliability, for narrowing the space between the via holes, or for reducing the diameter of the via holes).

The metal portion 15 included in the via-hole conductor 14 as above comprises: the first metal regions 17 composed of the copper particles 7; the second metal regions 18 mainly composed of at least one metal selected from the group consisting of tin, a tin-copper alloy, and a tin-copper intermetallic compound; the third metal regions 19 mainly composed of bismuth; and the fourth metal regions 22 mainly composed of the tin-bismuth solder particles. The weight ratio between Cu and Sn represented by Cu/Sn in the metal portion 15, is preferably in the range of 1.59 to 21.43. The significance of this Cu/Sn ratio will be described later.

On the other hand, the resin portion 16 included in the via-hole conductor 14 is made of cured material of curable resin. The curable resin is not particularly limited, but specifically, for example, a cured epoxy resin is particularly preferred in terms of excellent heat resistance and lower linear expansion coefficient.

The proportion of the resin portion 16 in the via-hole conductor 14 is preferably 0.1 to 50 mass%, and further preferably 0.5 to 40 mass%. When the proportion of the resin portion 16 is too large, resistance tends to increase, and when too small, preparation of a conductive paste tends to be difficult.

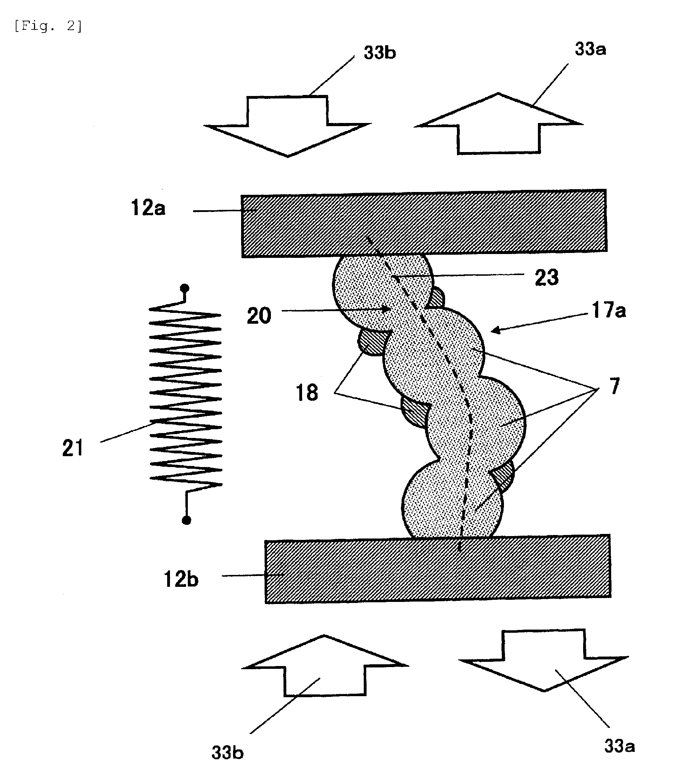

Next, the effect of the via-hole conductors 14 in the multilayer wiring board 11 will be schematically described with reference to Fig. 2.

Fig. 2 is an explanatory drawing for providing a description with focus on the conductive path 23 formed by one of the links 17a each formed by the Cu particles 7 being in contact with one another. Also, for convenience, the resin portion 16, etc. are not illustrated. Furthermore, "21" denotes a virtual spring illustrated for convenience in describing the effect of the via-hole conductor 14.

As illustrated in Fig. 2, the link 17a, which is formed by a number of the Cu particles 7 randomly coming into plane-to-plane contact with one another, forms the conductive path 23 for creating an electrical interlayer connection between the wirings 12a and 12b. At the plane-to-plane contact portion 20 where the Cu particles 7 are in contact with each other, the second metal region 18 is preferably formed in a manner such that it covers around, and extends astride, the plane-to-plane contact portion 20.

When internal stress occurs inside the multilayer wiring board 11, force, which is outwardly directed as indicated by arrows 33a, is applied inside the multilayer wiring board 11. Such internal stress occurs, for example, at the time of solder reflow or thermal shock tests, due to the differing thermal expansion coefficients among materials which compose the individual components.

Such outwardly-directed force is reduced by factors such as: deformation of the highly flexible Cu particles 7 themselves; elastic deformation of the link 17a formed by the Cu particles 7 coming into contact with one another; or slight shift in the contact positions among the Cu particles 7. At this time, the second metal regions 18 have a hardness that is greater than that of the Cu particles 7, and thus tend to resist deformation of the link 17a, particularly at the plane-to-plane contact portions 20. Therefore, in the case where the link 17a tends to keep on deforming without limitation, it does not deform to the point of the plane-to-plane contact portion 20 being divided, since the second metal region 18 regulates the deformation to a certain extent. With respect to the above, in the case where the link 17a formed by the Cu particles 7 being in contact with one another is likened to a spring, when a certain amount of force is applied to the link 17a, the link 17a keeps on deforming to a certain extent as if the spring is stretched; but when the deformation of the link 17a is likely to become greater, it is regulated by the hard second metal regions 18. A similar effect as above is also achieved when force, which is directed inwardly as indicated by arrows 33b, is applied to the multilayer wiring board 11. Thus, it is possible to ensure reliability of electrical connection, due to the link 17a acting as if it was the spring 21 and enabling regulation of deformation of the link 17a against forces in any direction, whether external or internal.

Next, to describe an exemplary method for producing the aforementioned multilayer wiring board 11, each step for the production will be described in detail with reference to the drawings.

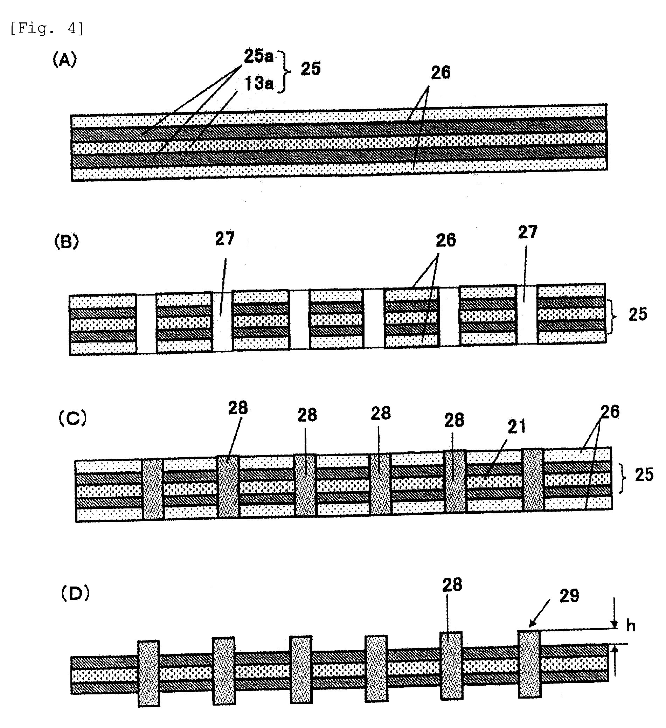

In the production method of the present embodiment, first, as illustrated in Fig. 4(A), protective films 26 are attached to both surfaces of a resin sheet 25. In the present embodiment, the resin sheet 25 is a laminate made of a heat-resistant resin sheet 13a with an uncured resin layer 25a laminated on both surfaces thereof. When the above resin sheet 25 is used, it would be possible obtain a thinner multilayer wiring board compared to a multilayer wiring board obtained by using a prepreg, as will be described later. Specifically, it would be possible to form an insulating resin layer having sufficient insulating properties, even if its thickness is, for example, 15 µm or less, or even 6 µm or less. The uncured resin layer 25a allows attachment of metal foil and a formed wiring.

The heat-resistant resin sheet 13a may be any resin sheet without particular limitation, as long as it is resistant to soldering temperatures. Specific examples thereof include a polyimide sheet, a liquid crystal polymer sheet, and a polyether ether ketone sheet. Particularly preferred among the above is the polyimide sheet.

The heat-resistant resin sheet 13a preferably has a thickness of 1 to 100 µm, further preferably 3 to 75 µm, and particularly preferably 7.5 to 60 µm.

An example of the uncured resin layer 25a is an adhesive layer that is uncured and made of an epoxy resin or the like. Also, the thickness of the uncured resin layer 25a per surface of the heat-resistant resin film is preferably 1 to 30 µm and further preferably 5 to 10 µm, in terms of contributing to make the multilayer wiring board thinner.

The protective film may be any resin film. Specific examples thereof include resin films of PET (polyethylene terephthalate), PEN (polyethylene naphthalate), and the like. The thickness of the resin film is preferably 0.5 to 50 µm and further preferably 1 to 30 µm. In the case of the above thickness, it is possible to reveal protrusions made from a via paste and of a sufficient height, by removing the protective films. This will be described later.

An example of a method for attaching the protective films 26 to the resin sheet 25, is a method in which the films are directly attached to the sheet with use of tackiness of the surface of the uncured resin layer 25a.

Next, as illustrated in Fig. 4(B), through-holes 27 are created by perforating the resin sheet 25 with the protective films 26 disposed thereon, starting from the outside of either one of the protective films 26. For the perforation, various methods such as drilling holes, etc. can be used, in addition to a non-contact processing method using a carbon dioxide gas laser, a YAG laser, or the like. The through-holes can have a diameter of 10 to 500 µm, or even about 50 to 300 µm.

Next, as illustrated in Fig. 4(C), the through-holes 27 are fully filled with via paste 28. The via paste 28 contains Cu particles, Sn-Bi solder particles containing Sn and Bi, and a curable resin component such as an epoxy resin.

The average particle size of the Cu particles is preferably in the range from 0.1 to 20 µm, and further preferably from 1 to 10 µm. When the average particle size of the Cu particles 7 is too small, in the via-hole conductor 14, there tends to be difficulty in forming the plane-to-plane contact portions as will be described later; and there also tends to be higher conductive resistance due to increased contact points among the particles. In contrast, when the average particle size of the Cu particles is too large, there tends to be higher conductive resistance due to difficulty in increasing the filling rate when forming the via-hole conductors 14 with a small diameter, such as 30 to 150 µmØ. Particularly, in the case of the via-hole conductor being extremely small with a maximum diameter of 30 to to 150 µmØ, the average particle size of the copper particles is preferably 3 to 10 µm.

Also, the Cu particles are not particularly limited to any particle form, and may specifically be, for example, spherical, flat, polygonal, scale-like, flake-like, in a form with surface projections, or the like. Furthermore, the particles may be primary particles, or may be secondary particles.

The Sn-Bi solder particles are not particularly limited, as long as they are solder particles containing Sn and Bi. The eutectic temperature (melting point) of the Sn-Bi solder particles can be changed to about 138°C to 232°C, by changing the proportions of the components therein or by adding various elements thereto. Moreover, the Sn-Bi solder particles may be improved in wettability, flowability, etc., by having indium (In), silver (Ag), zinc (Zn), or the like added thereto. Particularly preferred are Sn-58Bi solder and the like, being environmentally-friendly lead-free solders with a low eutectic temperature of 138 °C.

The average particle size of the Sn-Bi solder particles is preferably in the range of 0.1 to 20 µm, and further preferably 2 to 15 µm. In the case where the average particle size of the Sn-Bi solder particles is too small, melting of the particles tends to be difficult, due to increased specific surface area which results in increased proportion of an oxide film on the particle surface. On the other hand, in the case where the average particle size of the Sn-Bi solder particles is too large, the ability of the particles to fill the via holes tends to become poor.

The average particle size of the Sn-Bi solder particles covered with resin and interspersed in the via-hole conductor, is preferably about the same as or smaller than the average particle size of the Cu particles. Specifically, the average particle size of the Sn-Bi solder particles is preferably 0.3 to 1.0 times and further preferably 0.5 to 0.8 times that of the copper particles. The Sn-Bi solder particles being about the same as or smaller than the Cu particles in average particle size and remaining as resin-covered particles, contribute to cost reduction of the via paste. This is because a step of sieving the Sn-Bi solder particles or the like may be omitted.

In the via paste of the present embodiment, the tin-bismuth solder particles preferably include those having a particle size equal to or smaller than the average particle size of the copper particles. By allowing the via paste to contain the tin-bismuth solder particles having a particle size equal to or smaller than the average particle size of the copper particles, it would be possible for the fourth metal regions to be formed reliably. Also, in the via paste, the particle size of the tin-bismuth solder particles for forming the fourth metal regions, is preferably equal to or smaller than the average particle size of the copper particles. Specifically, it is preferably equal to or smaller than 2/3, and further preferably equal to or smaller than 1/2, of the average particle size of the copper particles. This is because when the solder particles with such a small size get caught between the copper particles, they can easily and effectively force out the epoxy resin that is caught between the copper particles. This is because, when the tin-bismuth solder particles having an average particle size equal to or smaller than that of the copper particles get caught between the copper particles, the solder particles may function in a manner similar to a movable plunger (or a gasket attached to a plunger top) in a cylindrical tube which constitutes an injector (or a syringe); that is, the solder particles caught between the copper particles allows the epoxy resin caught therebetween to easily move out from the space therebetween, as if the epoxy resin filled in an injector is pushed out of the injector. Also, by the via paste containing the tin-bismuth solder particles having a particle size equal to or smaller than the average particle size of the copper particles, at the time of compressing the copper particles and producing plane-to-plane contact between the copper particles, it is difficult for the tin-bismuth solder particles to remain in the space between the copper particles where the plane-to-plane contact portion is to be formed; and therefore, it would be difficult for the tin-bismuth solder particles to affect production of plane-to-plane contact between the copper particles.

To obtain the average particle size of the particles, one may be selected from mean number diameter, mean length, mean area diameter, and mean volume diameter, depending on which one is capable of the highest measurement accuracy (and also, repeatability). For the particle size, a mode value or a median value (also called "d50") is used. Examples of how to measure the particle size include use a commercially-available laser diffraction/light scattering device or of a particle distribution measuring device which applies the Coulter Principle; and use of an image of a vertical section of a sample taken with a SEM, to calculate the particle size.

Specific examples of the epoxy resin being the preferred curable resin component, include glycidyl ether epoxy resin, alycyclic epoxy resin, glycidyl amine epoxy resin, glycidyl ester epoxy resin, and other modified epoxy resins.

Also, a curing agent may be blended with the epoxy resin in a combination. The curing agent is not limited to any particular kind, but is particularly preferably a curing agent which contains an amine compound having at least one or more hydroxyl groups in its molecules. The above curing agent is preferable, in terms of working as a curing catalyst for the epoxy resin, and also, of having an effect of producing lower contact resistance at the time the particles join together, by reducing the oxide film that is on the surface of the Cu particles and on the surface of the Sn-Bi solder particles. Particularly preferred among the above is the amine compound with a boiling point higher than the eutectic temperature of the Sn-Bi solder particles, in terms of being highly effective, particularly in obtaining lower contact resistance at the time the particles join together.

Specific examples of the above amine compound include 2-methylaminoethanol (boiling point:160°C), N,N-diethylethanolamine (boiling point:162°C), N,N-dibutylethanolamine (boiling point: 229°C), N-methylethanolamine (boiling point:160°C), N-methyldiethanolamine (boiling point: 247°C), N-ethylethanolamine (boiling point:169°C), N-butylethanolamine (boiling point:195°C), diisopropanolamine (boiling point: 249°C), N,N-diethylisopropanolamine (boiling point:125.8°C), 2,2'-dimethylaminoethanol (boiling point:135°C), triethanolamine (boiling point: 208°C), and the like.

The via paste is prepared by mixing the Cu particles, the Sn-Bi solder particles containing Sn and Bi, and the curable resin component such as the epoxy resin. Specifically, the via paste is prepared by, for example, adding the Cu particles and the Sn-Bi solder particles to a resin varnish which contains an epoxy resin, a curing agent, and a predetermined amount of an organic solvent, and then mixing the resultant with a planetary mixer or the like.

The proportion of the curable resin component to be blended, relative to the total amount of the curable resin component and the metal component including the Cu particles and Sn-Bi solder particles, is preferably in the range from 0.3 to 30 mass%, and further preferably from 3 to 20 mass%, in terms of achieving lower resistance and of ensuring sufficient workability.

Also, with respect to the content of the Cu particles in the metal component, it is preferable that they are contained therein such that the weight ratio of Cu/Sn between Cu and Sn is in the range of 1.59 to 21.43. The reason for the above will be described later. Therefore, for example, when Sn-58Bi solder particles are used as the Sn-Bi solder particles, the content of the Cu particles relative to the total amount of the Cu particles and the Sn-58Bi solder particles, is preferably 40 to 90 mass%, and further preferably 55.8 to 65.5 mass%

The method for filling the through-holes with the via paste is not particularly limited. Specifically, for example, a method such as screen printing or the like is used. Note that in the production method of the present embodiment, when the through-holes are filled with the via paste, it is necessary that the amount filled is to the extent that the via paste flows out from the through-holes 27 formed in the resin sheet 25, so that when the protective films 26 are removed after the filling step, the via paste 28 partially protrudes from the through-holes 27, thereby allowing protrusions to be revealed.

Next, as illustrated in Fig. 4(D), the protective films 26 are removed from the surfaces of the resin sheet 25, thereby allowing the via paste 28 to partially protrude from the through-holes 27, as protrusions 29. Height "h" of the protrusions 29 depends on the thickness of the protective films, and is, for example, preferably 0.5 to 50 µm and further preferably, 1 to 30 µm. When the height of the protrusions 29 is too high, it is not preferable, since the paste may possibly overflow and spread around the through-holes 27 on the surfaces of the resin sheet 25 during a compression-bonding step that will be described later, thereby causing loss of surface smoothness. When too low, during the compression-bonding step that will be described later, pressure does not tend to be sufficiently exerted to the via paste filled in the through-holes.

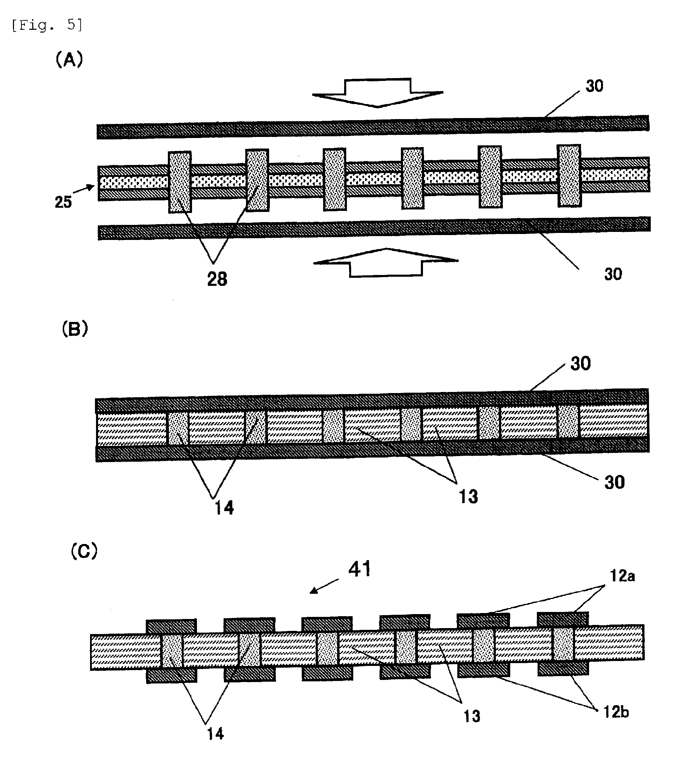

Next, as illustrated in Fig. 5(A), copper foils 30 are disposed on the resin sheet 25 and then pressed in directions indicated by arrows. Thus, the resin sheet 25 integrated with the copper foils 30 as illustrated in Fig. 5(B) results in formation of an insulating resin layer 13. In this case, at the beginning of the pressing, force is applied to the protrusions 29 with the copper foil 30 disposed thereon. Therefore, the via paste 28 filled in the through-holes 27 is compressed under high pressure. Thus, space among the Cu particles 7 contained in the via paste 28 are narrowed, causing the Cu particles 7 to deform and to come into plane-to-plane contact with one another.

Pressing conditions are not particularly limited, but the mold temperature is preferably set to be in the range from room temperature (20°C) to a temperature lower than the eutectic temperature of the Sn-Bi solder particles. Also, in this pressing step, a hot press machine may be used to promote curing of the uncured resin layers 25a, with the hot press machine heated to a temperature necessary to promote the curing.

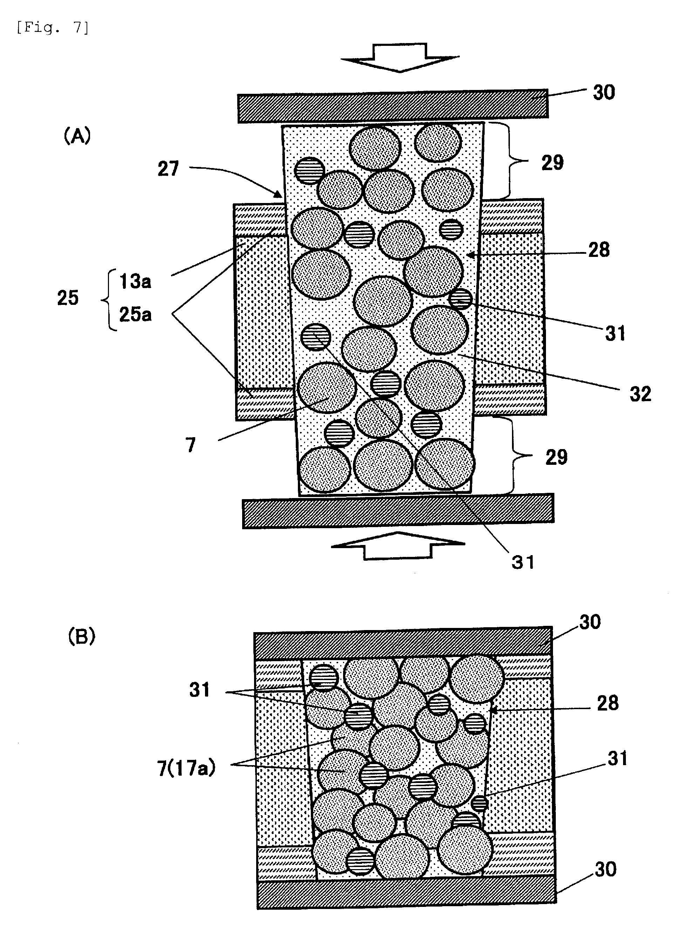

The manner in which the via paste 28 having the protrusions 29 is compressed, will now be described in detail with reference to Fig 7.

Fig. 7 is a schematic sectional view of the vicinity of the through-hole 27 in the resin sheet 25, which is filled with the via paste 28. Also, Fig. 7(A) illustrates the state before the compression, and Fig. 7(B) illustrates the state after the compression.

As illustrated in Fig. 7(A), the protrusions 29 protruding from the through-hole 27 created in the resin sheet 25 are pressed, with the copper foils 30 disposed on the protrusions 29. This causes the via paste 28 filled in the through-hole 27 to be compressed, as illustrated in Fig. 7(B). By pressurization caused during the compression, the curable resin component 32 may be partially forced out, onto the surfaces of the resin sheet 25. As a result, the Cu particles 7 and the Sn-Bi solder particles 31 filled in the through-hole 27 increase in density.

By appropriately selecting the content and particle size of the Cu particles 7 and the particle size of the Sn-Bi solder particles 31, it is possible for the Cu particles 7 to come into plane-to-plane contact with one another. During the compression, first, the Cu particles 7 come into point-to-point contact with one another, and then, they are pressed against one another as pressure increases. This causes the particles to deform and to come into plane-to-plane contact with one another, thereby forming plane-to-plane contact portions. As such, the Cu particles 7 coming into plane-to-plane contact with one another cause formation of the link 17a which serves to electrically connect, with low resistance, the upper wiring and the lower wiring. In this step, the link 17a, in which the copper particles 7 in the via paste 28 come into contact with one another via the plane-to-plane contact portions 20, is formed.

The via paste 28 is pressurized and compressed, preferably by compression bonding the copper foils 30 onto the resin sheet 25, and then applying a predetermined amount of pressure to the protrusions 29 of the via paste 28, the protrusions 29 having the copper foil 30 disposed thereon. This allows the copper particles 7 to come into plane-to-plane contact with one another, thereby forming first metal regions 17 including the link 7a of the copper particles 7. To make the copper particles 7 come into plane-to-plane contact with one another, they are preferably pressurized and compressed until they are plastically deformed against one another. Also, in this compression bonding step, it is effective to perform heating (or start heating) as necessary. This is because it is effective to carry out a heating step subsequent to the compression bonding step.

Further, it is effective to partially melt the Sn-Bi solder particles by heating them at a predetermined temperature, while maintaining the above compression-bonded state. By performing heating while maintaining the compression-bonded state and thus melting the solder particles, it is possible to prevent molten solder or the like, or resin or the like, from entering the plane-to-plane contact portion between the copper particles. Thus, it is effective to include a heating step as a part in the compression bonding step. Also, by starting the heating in the compression bonding step, productivity can be increased since the total time of the compression bonding step and the heating step can be shortened.

The compression is preferably carried out at a temperature in the range from room temperature (20°C) to a temperature lower than the melting temperature (or eutectic temperature) of the tin-bismuth solder particles in the via paste 28. By carrying out the compression in the above temperature range, a reaction which causes alloying of the tin-bismuth solder can be prevented during the compression step.

Also, the via paste compressed as above is heated, while the compression is maintained. Heating is carried out at a temperature equal to or higher than the melting temperature (or eutectic temperature) of the tin-bismuth solder particles that are used.

For example, second metal regions mainly composed of any one or more of tin, a tin-copper alloy, and a tin-copper intermetallic compound, are each preferably formed on the surface of the link of the copper particles, the surface excluding the area of plane-to-plane contact portion, in the manner of melting a part of the Sn-Bi solder particles at a temperature in the range from the eutectic temperature of the Sn-Bi solder particles, to the eutectic temperature plus 10°C; then, further heating the resultant at a temperature in the range from the eutectic temperature plus 20°C, to 300°C. It is effective to designate a step comprising the above compression bonding and heating, as one step. By this one step in which the compression bonding, the heating, and the metal region formation are performed in succession, it is possible to stabilize the formation reaction of each of the above metal regions, and to stabilize the structure of the vias themselves.

The links 17a are formed by compression, and then, the via paste 28 is further heated in a gradual manner until reaching a temperature equal to or higher than the eutectic temperature of the Sn-Bi solder particles 31. By the heating, the Sn-Bi solder particles 31 partially becomes molten in an amount equal to that in which the composition becomes molten at that reached temperature. Also, the second metal regions 18 mainly composed of tin, a tin-copper alloy, and/or a tin-copper intermetallic compound are each formed on the surface of, or around, the Cu particles 7 and the links 17a. In this case, the plane-to-plane contact portion 20, where the Cu particles 7 are in plane-to-plane contact with each other, is preferably covered by the second metal region 18 in a manner such that it extends astride the portion 20. The second metal regions 18 mainly composed of a layer of a Sn-Cu compound including Cu₆Sn₅ or Cu₃Sn (intermetallic compound), or of a tin-copper alloy, are formed from the Cu particles 7 and the molten Sn-Bi solder particles 31 coming into contact with one another and causing the Cu in the Cu particles 7 and the Sn in the Sn-Bi solder particles 31 to react with one another. On the other hand, third metal regions 18 mainly composed of Bi are formed from the molten state of the Sn-Bi solder particles 31 that continue to be in a molten state while Sn is being compensated from the Sn phase in the solder particles 31 and the Bi is remaining in the solder particles 31 to be deposited. This results in obtaining of the via-hole conductors 14 having the structure as illustrated in Fig. 1 (B). Also, the fourth metal regions 22 are formed in the manner of the Sn-Bi solder particles 31, each surrounded by a curable resin component 32, being partially interspersed in the via-hole conductor 14.

The fourth metal regions, each surrounded by the curable resin component 32 and activated due to their respective surfaces being reduced by an active agent (e.g., an amine-based additive) added in the via paste, are interspersed in the via-hole conductor. Reliability of the via-hole conductor is enhanced, by allowing the fourth metal regions, each surrounded by the curable resin component 32 and interspersed in the via-hole conductor, to serve as traps (or catchers) against moisture that enters from the outside, etc. or against oxidants, etc. This is because the tin-bismuth solder particles, which form the fourth metal regions, are affected by the moisture that enters from the outside or by the oxidants, etc., before the via-hole conductor is affected thereby.

More specifically, the Cu particles 7, which are made highly dense as above, come into contact with one another by compression. During the compression, first, the Cu particles 7 come into point-to-point contact with one another, and then, they are pressed against one another as pressure increases. This causes the particles to deform and to come into plane-to-plane contact with one another, thereby forming the plane-to-plane contact portions. The Cu particles 7 coming into plane-to-plane contact with one another as described above, causes formation of the links 17a which serve to electrically connect, with low resistance, the upper wiring and the lower wiring. Also, it is possible to form the links 17a with the Cu particles 17 in direct contact with one another, due to the plane-to-plane contact portions not being covered with the Sn-Bi solder particles 31. As a result, the conductive paths formed can be reduced in electrical resistance. Subsequently, heating is performed while in the above state, and the Sn-Bi solder particles 31 start to partially melt when temperature reaches the eutectic temperature thereof or higher. The composition of the solder that melts is determined by temperature, and the Sn that does not easily melt at the temperature during the heating remains as solid phase substance. Also, when the Cu particles 7 come into contact with the molten Sn-Bi solder, and the surface of the particles gets wet with the molten solder, interdiffusion between the Cu and the Sn progresses at the interface of the wet part, resulting in formation of the Sn-Cu compound layer, or the like. As above, the second metal regions 18 are produced in a manner such that they each come into contact with the surface of the Cu particles 7, the surface excluding the area of the plane-to-plane contact portion. The second metal region 18 is partially formed in a manner such that it extends astride the plane-to-plane contact portion. As above, in the case where the second metal region 18 partially covers the plane-to-plane contact portion in a manner such that it extends astride that portion, the plane-to-plane contact portions are strengthened and the conductive path becomes highly elastic. Also, further progression in the formation of the Sn-Cu compound layer or the like, or in the interdiffusion, causes the decrease of Sn in the molten solder. This decrease of Sn in the molten solder is compensated by the Sn solid phase, and therefore, the molten state is continued to be maintained. When Sn further decreases and Bi increases with respect to the ratio between Sn and Bi in the Sn-57Bi particles, segregation of Bi begins, and the second metal regions are formed in a manner such that they are deposited as solid-phase substances mainly composed of bismuth.

Well-known solder materials that melt at relatively low temperatures include Sn-Pb solders, Sn-In solders, Sn-Bi solders, etc. Among these materials, In is costly and Pb is highly environmentally unfriendly. On the other hand, the eutectic temperature of Sn-Bi solders is lower than the typical solder reflow temperature used when electronic components are surface mounted. Therefore, in the case where only Sn-Bi solder is simply used for via-hole conductors of a circuit board, there is a possibility of varied via resistance due to the solder in the via-hole conductors remelting at the time of solder reflow. On the other hand, in the case where the via paste of the present embodiment is used, Sn concentration in the Sn-Bi solder particles becomes lower due to Sn therein reacting with the surface of the Cu particles; and at the same time, the third metal regions are produced due to Bi being deposited after the Sn-Bi solder particles undergo heating and cooling. By allowing the third metal regions to be deposited and thus be present as described above, remelting of the solder in the via-hole conductors becomes unlikely, even under solder reflow. As a result, varied resistance is prevented even after solder reflow. Furthermore, the fourth metal regions 22 are formed, by a part of the Sn-Bi solder particles 31, each being surrounded by the curable resin component 32, being interspersed in the via-hole conductor. Reliability of the via-hole conductor is enhanced, by allowing the fourth metal regions 22, surrounded by the curable resin component 32 and interspersed in the via-hole conductor, to serve as traps (or catchers) against moisture that enters from the outside, etc., or against oxidants, etc.

The temperature for heating the via paste 28 after the compression is not particularly limited, as long as it is equal to or higher than the eutectic temperature of the Sn-Bi solder particles 31 and is within a temperature range that does not allow decomposition of the components of the resin sheet 25. Specifically, for example, in the case of using the Sn-58Bi solder particles as the Sn-Bi solder particles, the range is preferably 150 to 250°C, and further preferably around 160 to 230°C. By appropriately selecting the temperature at this time, it is possible to cure the curable resin component included in the via paste 28.

In this manner, the via-hole conductors 14 serving as an interlayer connection between the upper wiring and the lower wiring, are formed.

In the present embodiment, the content of the Cu particles in the metal component included in the via paste 28 is preferably such that the weight ratio of Cu/Sn between Cu and Sn is in the range of 1.59 to 21.43 as already mentioned. The reason for the above will be described in the following.

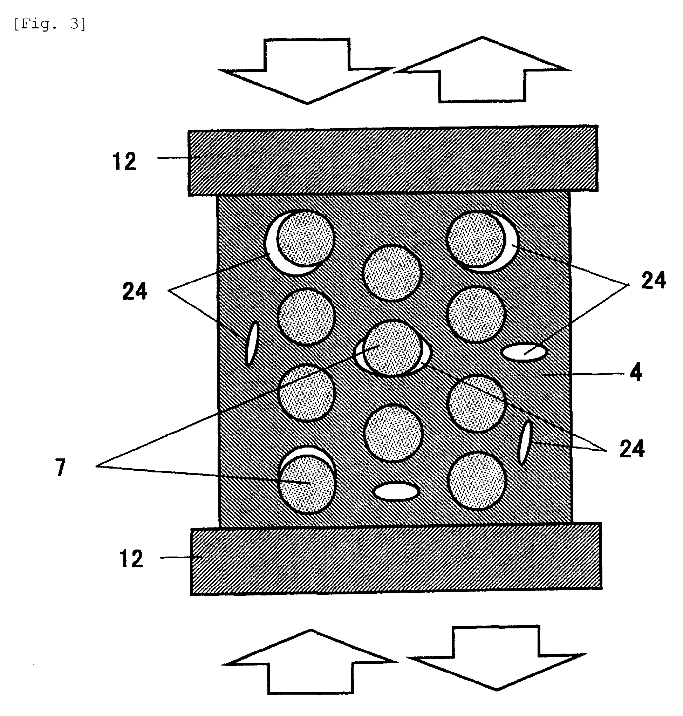

Fig. 3 is a schematic sectional view, showing one example of a via-hole conductor when Cu/Sn is smaller than 1.59.

As illustrated in Fig. 3, when the ratio of Cu/Sn is smaller than 1.59, the proportion of Cu in the via-hole conductor becomes smaller; plane-to-plane contact among the Cu particles 7 becomes difficult; and as a result, the Cu particles 7 tend to be present in an interspersed manner throughout a matrix comprising an intermetallic compound 4. In this case, the via-hole conductor itself also tends to become rigid with low spring-like properties, since the Cu particles 7 are rigidly bound by the hard intermetallic compound 4. Compared to the Cu particles 7, the intermetalic compound 4 such as Cu₆Sn₅ or Cu₃Sn is harder and more difficult to deform. According to what the inventors found out, the Vickers hardness for Cu₆Sn₅ and Cu₃Sn are about 378 Kg/mm² and about 343 Kg/mm², respectively, being remarkably higher than that for Cu which is 117 Kg/mm².

The Cu particles 7 and the intermetallic compound 4 differ in coefficient of thermal expansion. Therefore, during solder reflow, internal stress occurs due to this difference in coefficient of thermal expansion. As a result, voids or cracks 24 are easily created.

Also, voids easily occur when the weight ratio of Cu/Sn is smaller than 1.59. One of the critical factors which causes such occurrence of voids, is formation of Kirkendall voids due to the Kirkendall effect caused by contact and diffusion between Sn and Cu. Kirkendall voids tend to occur at the interface between the surface of the Cu particle and Sn packed in the space between the Cu particles, or between the surface of the Cu particle and an alloy containing Sn.

When the voids or cracks 24 are present at the interface between the copper particle 7 and the intermetalic compound 4 as illustrated in Fig. 3, there is a tendency for the voids or cracks 24 to easily propagate and spread. When Kirkendall voids occur, there is a tendency for such Kirkendall voids to easily propagate and spread as well. Particularly, in the case where the via-hole conductor has a small diameter, the voids or cracks 24 tend to become the cause of cohesive failure of the intermetallic compound 4, and furthermore, of breaking of the via-hole conductor. If such cohesive failure and interfacial failure occur inside the via-hole conductor, electrical resistance of the via portion would increase, and reliability thereof would be affected.

In the following, the case where the ratio of Cu/Sn is 1.59 or more will be schematically described with reference to Figs. 1B and 2.
When the ratio of Cu/Sn is 1.59 or more, the second metal region 18 included in the metal portion 15 physically protects, as illustrated in Fig. 1B, the plane-to-plane contact portions 20 where the Cu particles 7 come into plane-to-plane contact with one another, and the surface of the Cu particles 7. The arrows 33a and 33b illustrated in Fig. 2 indicate outwardly-directed force applied inside the via-hole conductor 14 and internal stress that occurs inside the via-hole conductor 14, respectively. In the case where the outwardly-directed force as indicated by the arrows 33a and the internal stress 33b are applied inside the via-hole conductor 14, force is moderated by deformations of the flexible Cu particles 7. Also, even if cracks occur in the second metal regions 18, electrical characteristics and reliability are not greatly affected, since the conductive paths formed by the links 17a, which are the Cu particles 7 in plane-to-plane contact with one another, are sufficiently secured. Note that deformation of the metal portion 15 as a whole is further suppressed within a certain range, since it is protected by the resin portion 16 in an elastic manner. Therefore, cohesive failure and interfacial failure do not tend to occur easily.

Also, when Cu/Sn is 1.59 or more, it is easier for the second metal region 18 to be formed such that it extends astride the plane-to-plane contact portion 20. Moreover, when the Cu/Sn is 1.59 or more, Kirkendall voids tend to easily occur in the second metal region 18, rather than inside the Sn-Bi solder particles packed in the space between the Cu particles, and at the interface between the Sn-Bi solder particle and the Cu particle. However, electrical characteristics and reliability of the via-hole conductor 14 are not easily affected by the Kirkendall voids which occur in the second metal region 18. This is because electrical conduction is sufficiently secured due to contact among the Cu particles 7.

Next, wirings 12a and 12b are formed as illustrated in Fig. 5(C). The wirings 12a and 12b are each formed by: forming a photoresist film on the surface of the copper foil 30 that is attached to the surface layer; patterning the photoresist film by selective exposure through a photomask; developing the photoresist film; etching the resultant to remove the copper foil in a selective manner, that is, to remove the copper other than the wiring portions; and then, removing the photoresist film. A liquid resist or a dry film may be used to form the photoresist film.

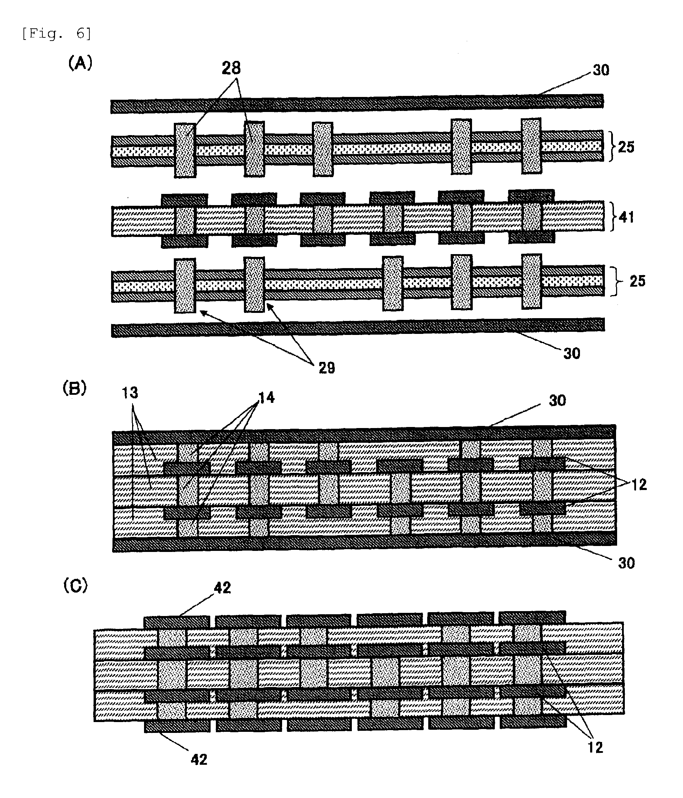

The above step results in obtaining a wiring board 41 in which an interlayer connection is created between the upper wiring 12a and the lower wiring 12b via the via-hole conductors 14; and of which both surfaces have circuits formed thereon. Further, by multilayering the above wiring board 41, a multilayer wiring board 11 in which interlayer connections are created among layers of circuits, as illustrated in Fig. 1 (A), is obtained. The manner in which the wiring board 41 is multilayered, will be described with reference to Fig. 6.

First, as illustrated in Fig. 6(A), the resin sheet 25 having the protrusions 29 made of the via paste 28 that is obtained in the same manner as in Fig. 4(D), is disposed on both surfaces of the wiring board 41 obtained as described above. Further, a copper foil 30 is disposed on the outer surface of each of the resin sheets 25, thereby forming a stacked structure. Then, the stacked structure is placed into a mold for pressing, followed by pressing and heating under the conditions as described above to obtain a laminate as illustrated in Fig. 6(B). Then, new wirings 42 are formed by performing the photo processing as described above. By additionally repeating the above multilayering process, a multilayer wiring board 11 is obtained, as illustrated in Fig. 6(C).

### [Second Embodiment]

For a second embodiment, a description will be given of one example which uses, when producing the multilayer wiring board 11 of the first embodiment, an uncured or semi-cured (B-stage) prepreg 125 in place of the resin sheet 25. The prepreg 125 is obtained by impregnating a fiber sheet with a resin varnish, and then drying the resultant. Except for using the prepreg 125 in place of the resin sheet 25, the second embodiment is the same as the first embodiment. Therefore, reference numerals used for the second embodiment are the same as those used for the first embodiment, with respect to parts shared between the two. Also, detailed descriptions are omitted for matters which are the same as those regarding the first embodiment.

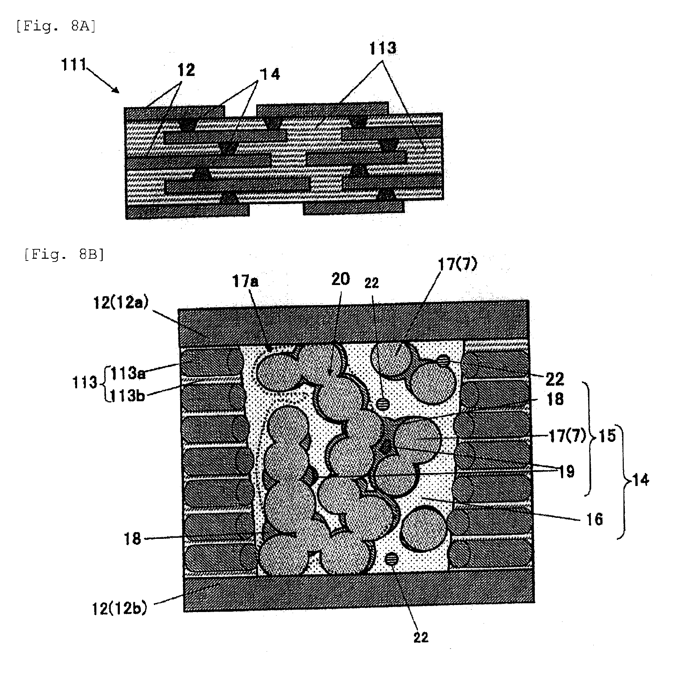

Fig. 8(A) is a schematic sectional view of a multilayer wiring board 111 of the present embodiment. Also, Fig. 8(B) is an enlarged schematic sectional view of showing the vicinity of a via-hole conductor 14 in the multilayer wiring board 111 of Fig. 8(A). In Fig. 8, Ref. No. 12 (12a, 12b) denotes wirings, Ref. No. 113 denotes an insulating resin layer, and Ref. No. 14 denotes the via-hole conductor. The via-hole conductor 14 comprises a metal portion 15 and a resin portion 16. The insulating resin layer 113 is a fiber-containing resin sheet in which a fiber sheet 113a is impregnated with a cured resin 113b. The metal portion 15 comprises: first metal regions 17 formed from Cu particles 7; second metal regions 18 mainly composed of at least one metal selected from the group consisting of tin, a tin-copper alloy, and a tin-copper intermetallic compound; third metal regions 19 mainly composed of Bi; and fourth metal regions 22 which are tin-bismuth particles. At least a part of the Cu particles 7 forms links 17a, by coming into plane-to-plane contact with one another. The links 17a are as those illustrated within the area outlined by dotted lines, and serves as low-resistance conductive paths that electrically connect the upper wiring 12a and the lower wiring 12b.

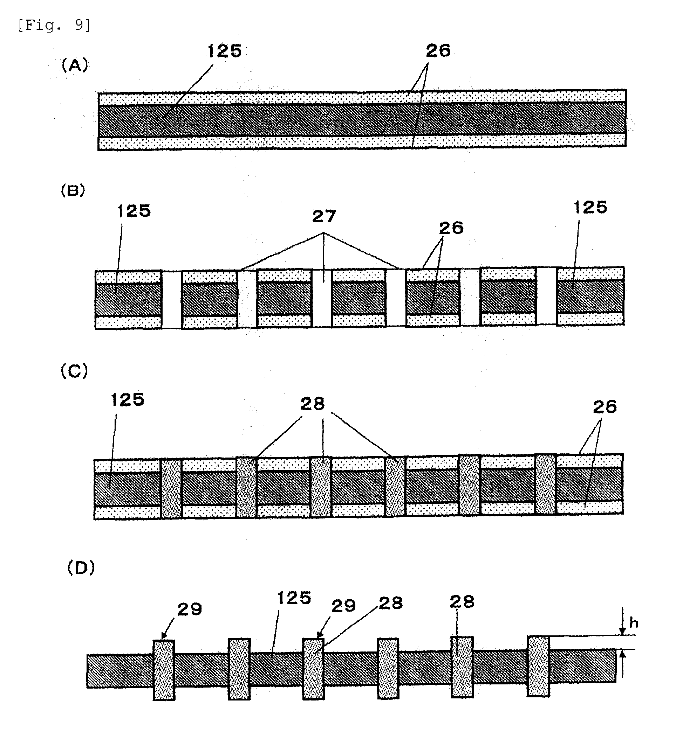

Next, to describe an exemplary method for producing the aforementioned multilayer wiring board 111, each step for the production will be described in detail with reference to Figs. 9 to 11.
In the production method of the present embodiment, first, as illustrated in Fig. 9(A), a protective film 26 is attached to both surfaces of an uncured or semi-cured (B-stage) prepreg 125.

Preferably used as the prepreg 125 is, for example, an uncured or semi-cured (B-stage) prepreg that is obtained by impregnating a fiber base material with a thermally curable resin varnish, followed by drying. The fiber base material may be a woven or non-woven fabric. Specific examples thereof include: glass fiber fabrics such as glass cloth, glass paper, and glass mat; kraft paper; linter sheet; natural fiber fabric; and organic fiber fabric made of aramid fibers. An example of a resin component contained in the resin varnish is an epoxy resin. Inorganic fillers, etc. may further be contained in the resin varnish.

Examples of a protective film 26 are the same as those given for the first embodiment. An example of a method for attaching the protective films 26 to the prepreg 125, is a method in which the films are attached with use of tackiness of the prepreg 125 surface, in the case where the prepreg 125 surface has tackiness.

Next, as illustrated in Fig. 9(B), through-holes 27 are created by perforating the prepreg 125 with the protective films 26 disposed thereon, starting from the outside of either one of the protective films 26. For the perforation, various methods such as drilling holes, etc. can be used, in addition to a non-contact processing method using a carbon dioxide gas laser, a YAG laser, or the like. The through-holes can have a diameter of 10 to 500 µm, or even about 50 to 300 µm.

Next, as illustrated in Fig. 9(C), the through-holes 27 are fully filled with a via paste 28. The via paste 28 contains Cu particles, Sn-Bi solder particles containing Sn and Bi, and a curable resin component such as an epoxy resin. For the via paste 28, the same one as that described for the first embodiment is used.

Next, as illustrated in Fig. 9(D), the protective films 26 are removed from the surfaces of the prepreg 125, thereby allowing the via paste 28 to partially protrude, as protrusions 29, from the through-holes 27 created in the prepreg 125. Height "h" of the protrusions 29 depends on the thickness of the protective films, and is, for example, preferably 0.5 to 50 µm and further preferably, 1 to 30 µm. When the height of the protrusions 29 is too high, it is not preferable, since the paste may possibly overflow and spread on the surfaces of the prepreg 125 around the through-holes 27 during a compression-bonding step that will be described later, thereby causing decreased surface smoothness. When too low, during the compression-bonding step that will be described later, pressure does not tend to be sufficiently exerted to the via paste filled in the through-holes.

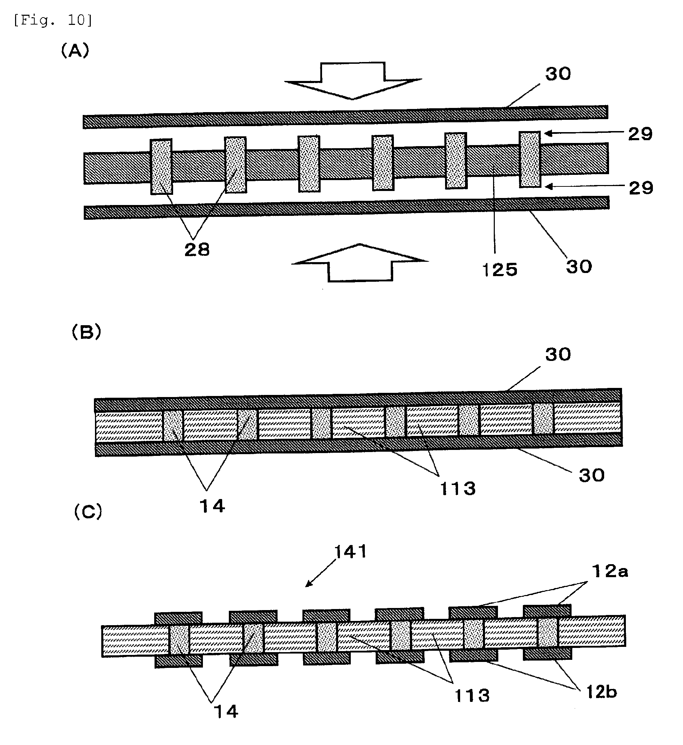

Next, as illustrated in Fig. 10(A), a copper foil 30 is disposed on both surfaces of the prepreg 125 and then pressed in directions indicated by arrows. Thus, the prepreg 125 integrated with the copper foils 30 as illustrated in Fig. 10(B) results in formation of an insulating resin layer 113. In this case, at the beginning of the pressing, force is applied to the protrusions 29 with the copper foil 30 disposed thereon. Therefore, the via paste 28 filled in the through-holes in the prepreg 125 is compressed with great force. Thus, space among the Cu particles 7 contained in the via paste 28 are narrowed, and the Cu particles 7 come into contact with one another.

Pressing conditions are not particularly limited, but the mold temperature is preferably set to be in the range from room temperature (20°C) to a temperature lower than the eutectic temperature of the Sn-Bi solder particles.

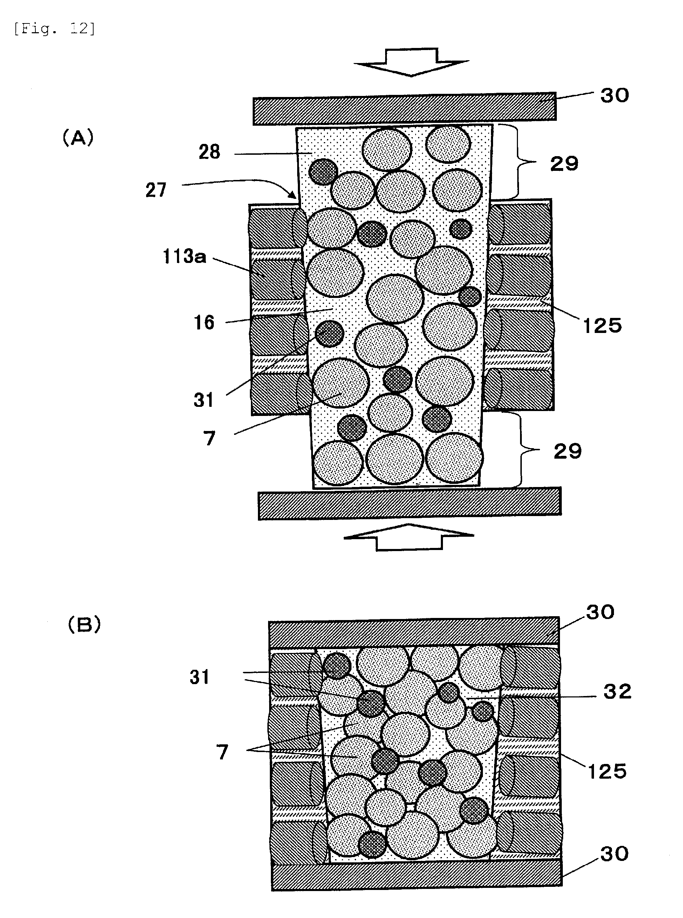

The manner of compressing the via paste 28 filled in the through-holes of the prepreg 125 and the via paste 28 forming the protrusions 29, will now be described in detail with reference to Fig. 12. Fig. 12 is a schematic sectional view showing the vicinity of the through-hole 27 in the prepreg 125 that is filled with the via paste 28. Fig. 12(A) shows the state before the compression, and Fig. 12(B) shows the state after the compression. Ref. No. 113a denotes the fiber base material that is included in the prepreg 125.

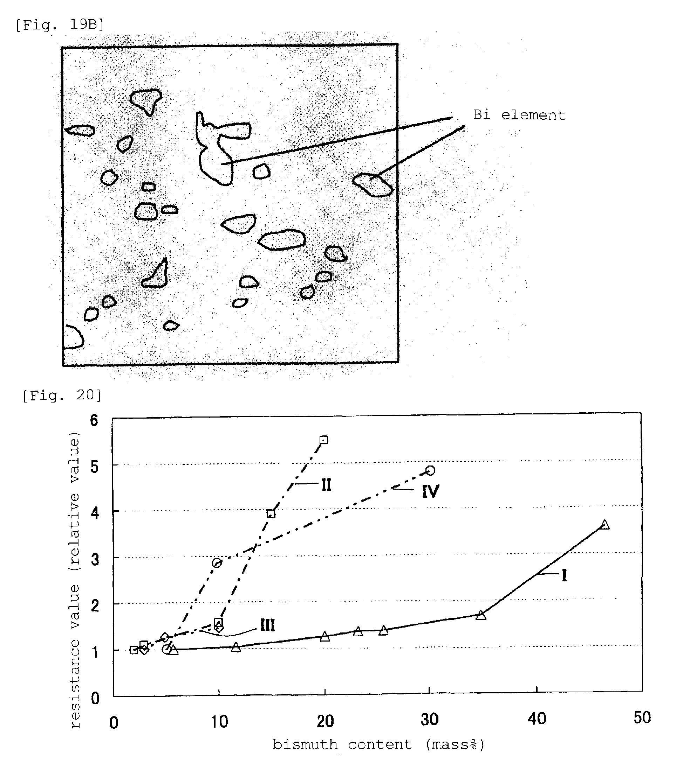

As illustrated in Fig. 12(A), the protrusions 29 protruding from the through-hole 27 created in the prepreg 125 are pressed, with the copper foils 30 disposed on the protrusions 29. This causes the via paste 28 filled in the through-hole 27 to be compressed, as illustrated in Fig. 19(B). By pressurization caused during the compression, the curable resin component 32 partially permeates into the prepreg 125. As a result, the Cu particles 7 and the Sn-Bi solder particles 31 filled in the through-hole 27 increase in density.

The Cu particles 7 which are made highly dense as above, come into contact with one another. During the compression, first, the Cu particles 7 come into point-to-point contact with one another, and then, they are pressed against one another as pressure increases. This causes the particles to deform and to come into plane-to-plane contact with one another, thereby forming plane-to-plane contact portions. As such, the Cu particles 7 coming into plane-to-plane contact with one another, cause formation of the links which serve to electrically connect, with low resistance, the upper wiring and the lower wiring. In this manner, the via-hole conductors 14 serving as an interlayer connection between the upper wiring and the lower wiring, are formed.

Next, wirings 12 (12a, 12b) are formed as illustrated in Fig. 10(C). The wirings 12 are each formed by: forming a photoresist film on the surface of the copper foil 30 that is attached to the surface layer; patterning the photoresist film by selective exposure through a photomask; developing the photoresist film; etching the resultant to remove the copper foil in a selective manner, that is, to remove the copper other than the wiring portions; and then, removing the photoresist film. A liquid resist or a dry film may be used to form the photoresist film.

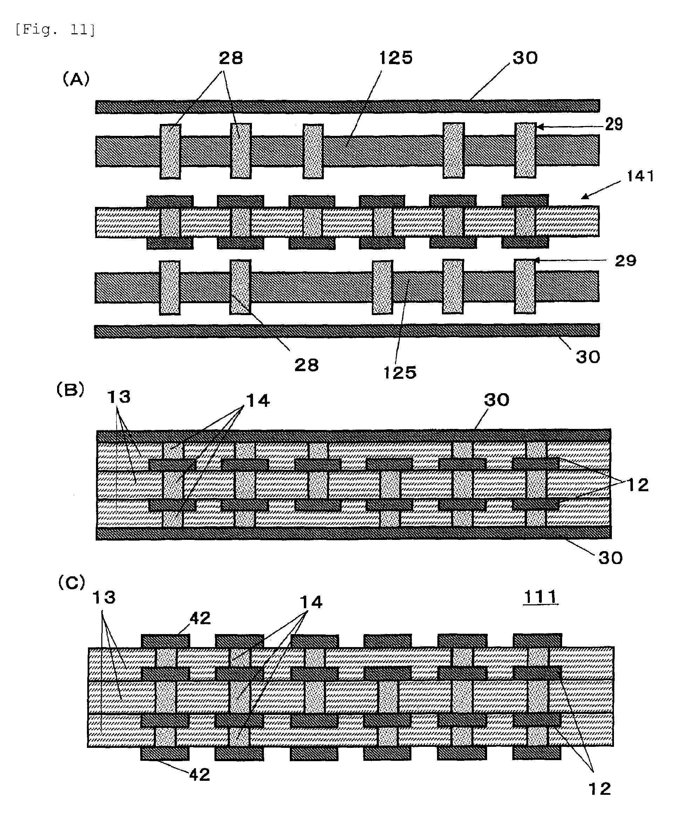

The above step results in obtaining a wiring board 141 in which an interlayer connection is created between the upper wiring 12a and the lower wiring 12b via the via-hole conductors 14; and of which both surfaces have circuits formed thereon. Further, by multilayering the above wiring board 141, a multilayer wiring board 111 in which interlayer connections are created among layers of circuits, is obtained. The manner of further multilayering the wiring board 141 will be described with reference to Fig. 11.

First, as illustrated in Fig. 11 (A), the prepreg 125 having the protrusions 29 made of the via paste 28 that is obtained in the same manner as in Fig. 9(D), is disposed on both surfaces of the wiring board 141 obtained as described above. Further, a copper foil 30 is disposed on the outer surface of each of the prepregs 125, thereby forming a stacked structure. Then, the stacked structure is placed into a mold for pressing, followed by pressing and heating under the conditions as described above to obtain a laminate as illustrated in Fig. 11 (B). Then, new wirings 42 are formed by performing the photo processing as described above. By additionally repeating the above multilayering process, a multilayer wiring board 111 is obtained.

Next, the present invention will be described more specifically by way of Examples. Note that the contents of the Examples are not to be in any way construed as limiting the scope of the present invention.

### [Example 1]

First, a description will be given on all of the raw materials used in the present Example.
● Cu particles: "1100Y" with an average particle size of 5 µm, available from Mitsui Mining & Smelting Co., Ltd.
● Sn-Bi solder particles: Sn42-Bi58, with an average particle size of 5 µm and an eutectic temperature of 138°C, available from Yamaishi Metal Co., Ltd.
● Epoxy resin: "jeR871" available from Japan Epoxy Resin K.K.
● Curing agent 1: 2-methylaminoethanol with a boiling point of 160°C, available from Nippon Nyukazai Co., Ltd.
● Curing agent 2: amine adduct-based curing agent (a solid) with a boiling point of 120 to 140°C, available from Ajinomoto Fine-Techno Co., Ltd.
● Curing agent 3: 2,2'-dimethylaminoethanol with a boiling point of 135°C
● Resin sheet: a 75 µm-thick, 500 mm (height) x 500 mm (width) polyimide film, with a 12.5 µm-thick uncured epoxy resin layer laminated on both surfaces of the film
● Protective film: a 25 µm-thick PET sheet
● Copper foil (thickness: 25 µm)

### (Preparation of via paste)

The Cu particles, the Sn42-Bi58 solder particles, the epoxy resin, and the curing agent were blended at a blend ratio as in Table 1, and then mixed with a planetary mixer, thereby preparing a via paste.

### (Production of Multilayer Wiring Board)

The protective film was attached to both surfaces of the resin sheet. Then, by using a laser from the outer side of the protective films attached thereto, 100 or more perforations having a diameter of 150 µm were created.
Next, the through-holes were fully filled with the prepared via paste. Then, the protective films on the both surfaces were removed, thereby revealing protrusions formed by the via paste partially protruding from the through-holes.
Next, the copper foil was disposed on the both surfaces of the resin sheet, so as to cover the protrusions. Then, a laminate of the copper foils and the resin sheet was placed on the lower mold of a pair of molds for heat pressing, with a release paper placed between the laminate and the mold. Thereafter, the temperature for the heat pressing was increased from a room temperature of 25 degrees to a maximum temperature of 220°C in 60 minutes, kept at 220 °C for 60 minutes, and then cooled down to the room temperature in 60 minutes. Note that the pressure for the pressing was 3 MPa. In this manner, a multilayer wiring board was obtained.

### (Evaluation)

### <Resistance Test>

The 100 via-hole conductors formed in the obtained multilayer wiring board were measured for resistance by a four-terminal method. Then, for each of the 100 via-hole conductors, average resistance and maximum resistance were obtained. For maximum resistance, values lower than 2 mΩ were evaluated as "A", values equal to 2 to 3 mΩ were evaluated as "B", and values exceeding 3 mΩ were evaluated as "C". It can be said that if maximum resistance is low, the standard deviation δ of the resistance would also be low.

### <Peel Test>

The via-hole conductors were checked for their adhesiveness with respect to separation (or breakage) of the copper foil on the surface of the obtained multilayer wiring board. Instances resulting in no separation were evaluated as "A"; instances resulting in separation, but with difficulty, were evaluated as "B"; and instances resulting in easy separation were evaluated as "C".

### <Initial Resistance>

The 100 via holes formed in the multilayer wiring board were measured for connection resistance by a four-terminal method. For initial resistance, via-hole conductors exhibiting values equal to or lower than 1 Ω were evaluated as "A", via-hole conductors exhibiting values mixed with those equal to or lower than 1 Ω and those exceeding 1 Ω were evaluated as "B", and via-hole conductors exhibiting only values exceeding 1 Ω were evaluated as "C".

### <Connection Reliability>

The multilayer wiring board measured for initial resistance was subjected to a thermal cycle test of 500 cycles. The via-hole conductors with 10% or lower percent of change from the initial resistance was evaluated as "A", and those with higher than 10% of change from the initial resistance was evaluated as "B".

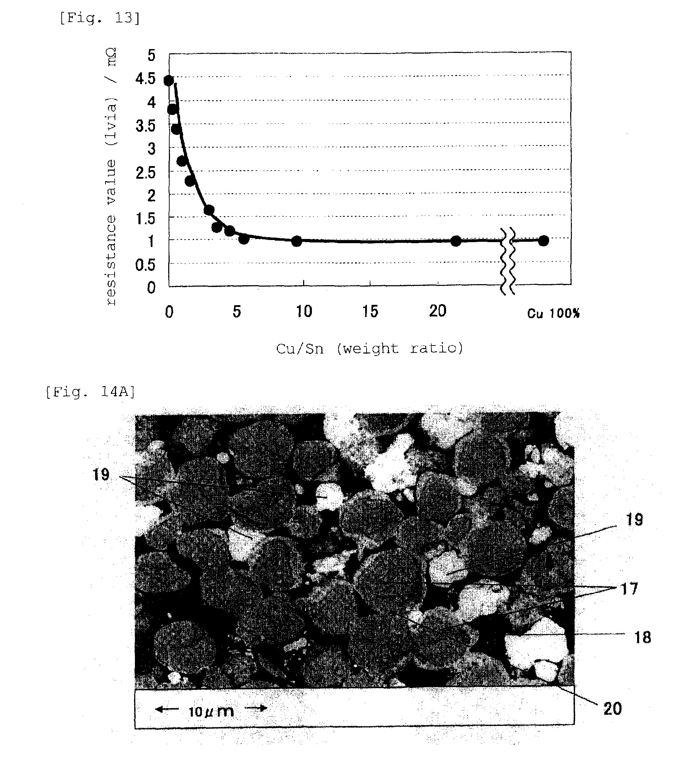

The results are shown in Table 1. Fig. 13 is a graph on which average resistance values relative to Cu/Sn mass ratios are plotted.

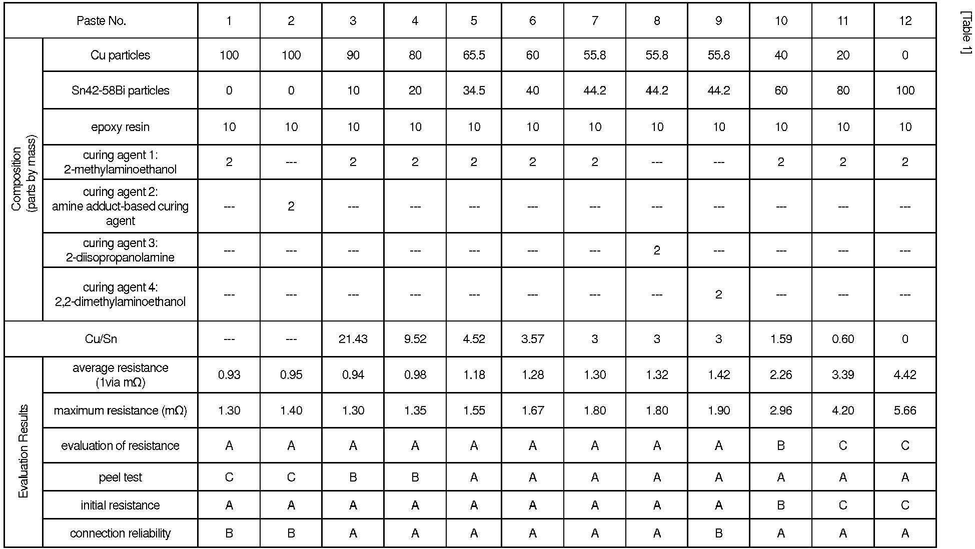

From the graph of Fig. 13, it is evident that resistance rapidly declines from where the weight ratio of Cu/Sn is near 1.59, and then near 3. This is presumed to be due to a larger percentage of plane-to-plane contact among the Cu particles of lower resistance, due to increase in the proportion of the Cu particles. That is, it is presumed to be due to there being hardly any metal, higher in resistance than Cu, present between the adjacent Cu particles. Moreover, as shown in the SEM images that will be described later, an excessive amount of the Sn42-Bi58 solder particles are found to be present, surrounded by the epoxy resin, when the weight ratio of Cu/Sn is 1.59 or more.
Moreover, it is presumed that reliability of the via-hole conductor is enhanced, by allowing the fourth metal regions, surrounded by the thermally curable resin component 32 and interspersed in the via-hole conductor, to serve as traps (or catchers) against moisture that enters from the outside, etc. or against oxidants, etc. This is because the tin-bismuth solder particles, which form the fourth metal regions, are affected by the moisture that enters from outside of the wiring board, etc. or by the oxidants, etc., before the via-hole conductor is affected thereby.

In other words, the above is presumed to be due to a metal higher in resistance than Cu being interspersed among the Cu particles 7, in the case where Cu/Sn is smaller than 1.59, which is when resistance rapidly increases.

Also, it is evident from Table 1 that average resistance and maximum resistance become 3 mΩ or lower when the proportion of the Sn42-58Bi particles is 60 mass% or less; and 2 mΩ or lower when 44.2 mass% or less, and thus lowering to an extreme extent. However, it is evident that separation of the copper foil occurs easily when the Sn42-58Bi particles are not included. On the other hand, it is evident that as the Sn42-58Bi particles increase, separation of the copper foil becomes more difficult.

Also, it is evident that both lower resistance and higher reliability are achieved when the proportion of the Sn42-58Bi particles is in the range of 10 to 60 mass%. If the proportion of the Sn42-58Bi particles is too small, connection reliability would be insufficient, since there would be less of the second metal regions present around the plane-to-plane contact portions where the Cu particles are in contact with one another. On the other hand, if the proportion of the Sn42-58Bi particles is too high, there would be too much of the second metal regions. This would lessen the plane-to-plane contact portions where the Cu particles are in contact with one another, and as a result, resistance would tend to become higher.

Also, comparing the multilayer wiring boards obtained by using Pastes No. 7 to 9, it is evident that in the cases of Pastes No. 7 and No. 8, each in which the boiling point of the curing agent is higher than the 138°C eutectic temperature of the Sn42-58Bi particles, there is better balance between achieving lower resistance values and achieving higher reliability. In instances of a low boiling point, the oxidation layer on the surface of the solder particles would be reduced, and volatilization of the curing agent would start before the solder particles melt. This would cause the region of the metal portion to become smaller, thus causing a problem with respect to connection reliability of the via-hole conductor. Note that the boiling point of the curing agent is preferably 300°C or lower. If higher than 300°C, the curing agent would be atypical and its reactivity may be affected.

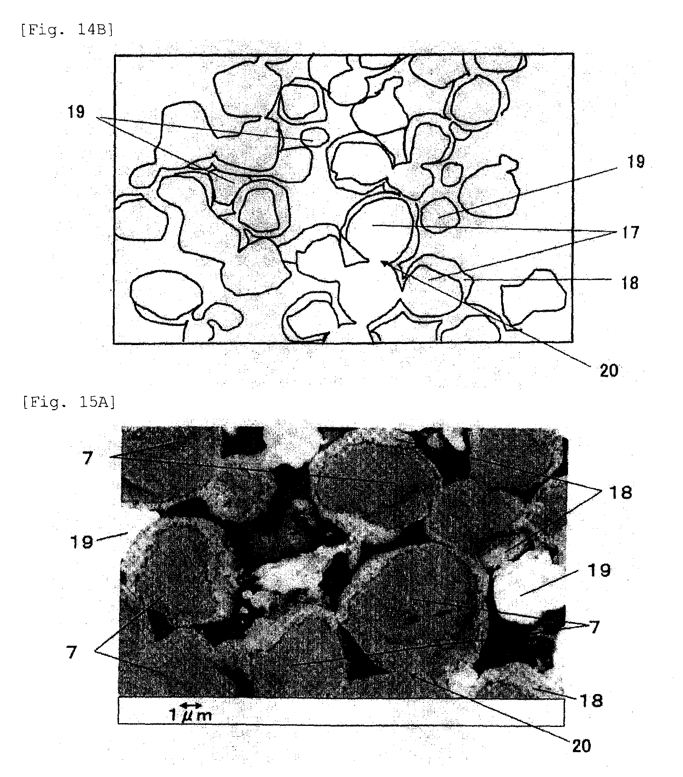

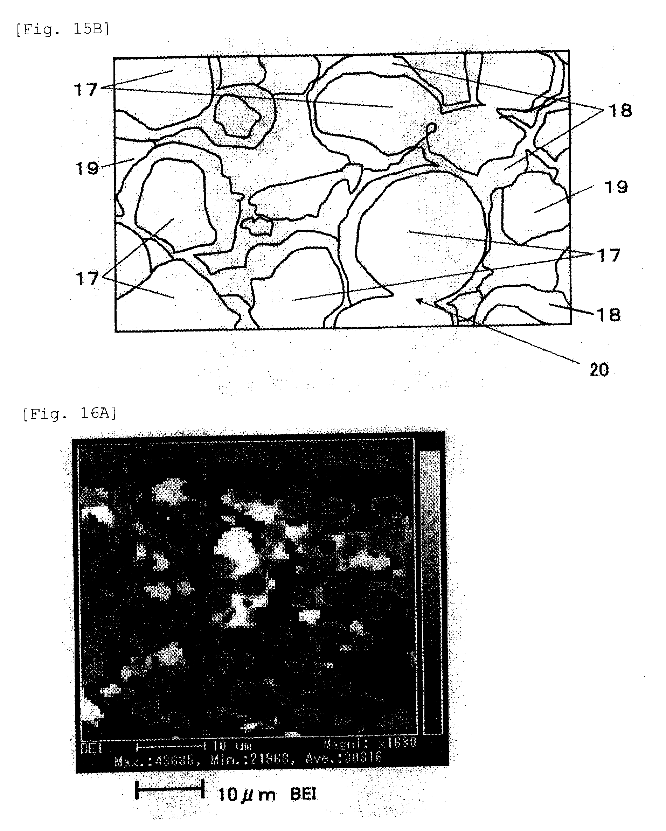

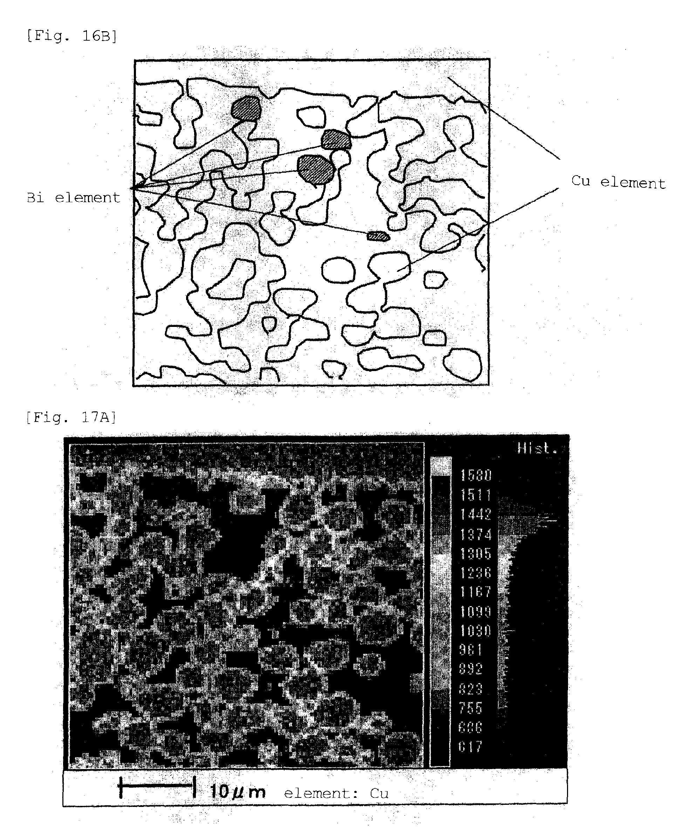

Herein, shown in Figs. 14A and 15A and in Figs. 14B and 15B are exemplary images created by a scanning electron microscope (SEM), and their tracings, respectively, of a vertical section of the via conductor in the multilayer wiring board according to the present invention, obtained by using Paste No. 6. Figs. 14A and 15A are images at 3000-times magnification and 6000-times magnification, respectively. Also, shown in Figs. 16A and 16B are an SEM image and its tracing, respectively, of a vertical section of the via conductor, that have been analyzed with use of an EPMA (electron probe micro-analyzer).

From Figs. 14A to 16A, it is evident that the obtained via-hole conductor is highly filled with the Cu particles 7; and that the plane-to-plane contact portions 20 are formed by the Cu particles 7 coming into plane-to-plane contact with one another. It is evident from the above, that conductive paths with low resistance are formed. Also, it is evident that the second metal regions 18 mainly composed of tin (Sn), a tin-copper intermetallic compound, or a tin-copper alloy, are formed on the plane-to-plane contact portion 20 or on the surface of the copper particles 7; or in a manner such that it extends astride the plane-to-plane contact portion 20. Also, it is evident that the third metal regions 19 mainly composed of Bi which has high resistance, are substantially not in contact with the Cu particles. It is presumed that, with respect to these third metal regions, Bi is deposited at high concentrations due to Sn in the Sn42-58Bi particles forming an alloy with Cu (e.g., intermetallic compound) on the surface of the Cu particles 7.

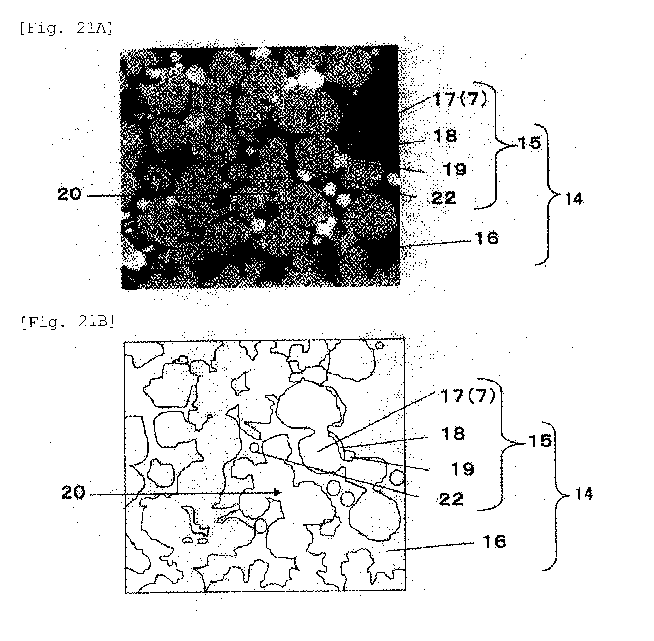

Fig. 21A shows another SEM image of a vertical section of the via-hole conductor in the multilayer wiring board, obtained by using Paste No. 6. Fig. 21B is its tracing. From the obtained SEM image, it is evident that the via-hole conductor is highly filled with the Cu particles 7; that the plane-to-plane contact portions 20 are formed by the Cu particles 7 coming into plane-to-plane contact with one another; and that the Cu particles 7 form the first metal regions 17. From the above, it is evident that conductive paths with low resistance are formed. Also, it is evident that the second metal regions 18 mainly composed of tin (Sn), a tin-copper intermetallic compound, or a tin-copper alloy, are formed on the plane-to-plane contact portion 20 or on the surface of the copper particles 7; or in a manner such that it extends astride the plane-to-plane contact portion 20. Also, it is evident that the third metal regions 19 mainly composed of Bi which has high resistance, are substantially not in contact with the Cu particles. It is presumed that, with respect to these third metal regions, Bi is deposited at high concentrations due to Sn in the Sn42-58Bi particles forming an alloy with Cu (e.g., intermetallic compound) on the surface of the Cu particles 7. Also, it is evident that the fourth metal regions 22, that is, the Sn42-58Bi particles not contributing to the formation of the second metal regions, are not present inside the conductive path formed by plane-to-plane contact produced among the Cu particles, but are independently present in spaces created among the other regions. It is considered that by the above, connection formed by the via-hole conductor would not be adversely affected and would be excellent in terms of both initial resistance and reliability, even if the Sn-Bi particles remain as they are without contributing to the formation of the second metal regions, due to local deviations in the ratio between the Cu particles and the Sn-Bi particles.

As above, it is preferable that the Cu particles 8 (or the first metal regions 17) are dominant in the via-hole conductor; and that excessive components in the Sn42-58Bi particles added for further strengthening of the plane-to-plane contact portions 20 included in the first metal regions 17, that is, components not contributing to the formations of the second metal regions 18 and the third metal regions 19, are allowed to remain in the via-hole conductor as the fourth metal regions 22, in a manner such that they do not affect other portions or regions therein.

As above, by allowing excessive components in the added Sn42-58Bi particles, that is, components not contributing to formations of the second metal regions 18 and the third metal regions 19, to remain as the fourth metal regions 22 in the via-hole conductor in a manner such that they do not affect other portions and regions therein, it is possible to further reduce effects caused by variation in the paste composition (in a production lot, or in-between production lots) or caused by precipitation of the paste (e.g., difference in specific gravity of the metal particles); and to stabilize quality of the via portions in a production lot or in-between production lots of the multiplayer wiring board, or of the via portions among different kinds of the multiplayer wiring boards. This is to prevent the via-hole conductor properties from being affected, by allowing the Sn42-58Bi particles of an amount necessary and sufficient in forming the via-hole conductor, to contribute to forming the second metal regions 18 and the third metal regions 19; and by allowing the non-reactive, excessive Sn42-58Bi particles to be separated from the contributing particles by the resin, or to be interspersed throughout a matrix of the resin. As above, by putting into the paste in advance the Sn42-58Bi particles of an amount exceeding the amount contributing to the reactions, it is possible to obtain the effect of suppressing variation in the paste or in the via-hole conductor.

The total amount (e.g., weight) of Sn-Bi present as the fourth metal regions is preferably equal to or lower than, and further preferably equal to or lower than 50% of, the total amount (e.g., weight) of Sn-Bi contributing to formations of the second and third metal regions. This is because, in the case where the total amount (e.g., weight) of Sn-Bi present as the fourth metal regions is greater than that contributing to formations of the second and third metal regions, formation of the via-hole conductor with stability may be affected.

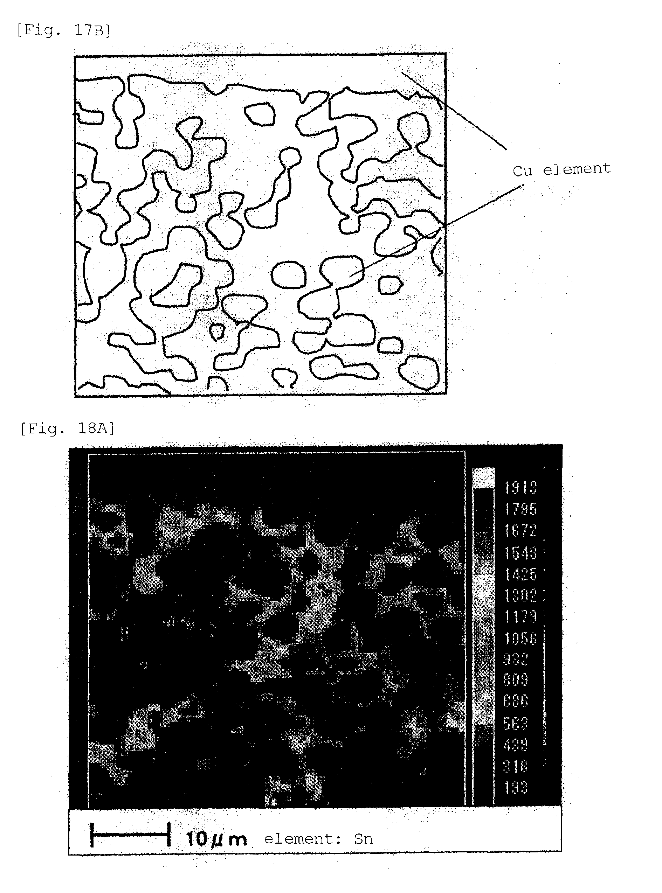

Figs. 17A and 17B are an image and its tracing, respectively, of an elemental map of Cu in the SEM image of Fig. 16A analyzed with EPMA.

From Figs. 17A and 17B, it is evident that in the obtained via-hole conductor, the Cu particles are present in a highly dense and random manner. It is also evident that the Cu particles directly come into plane-to-plane contact with one another, thereby being electrically connected to one another.

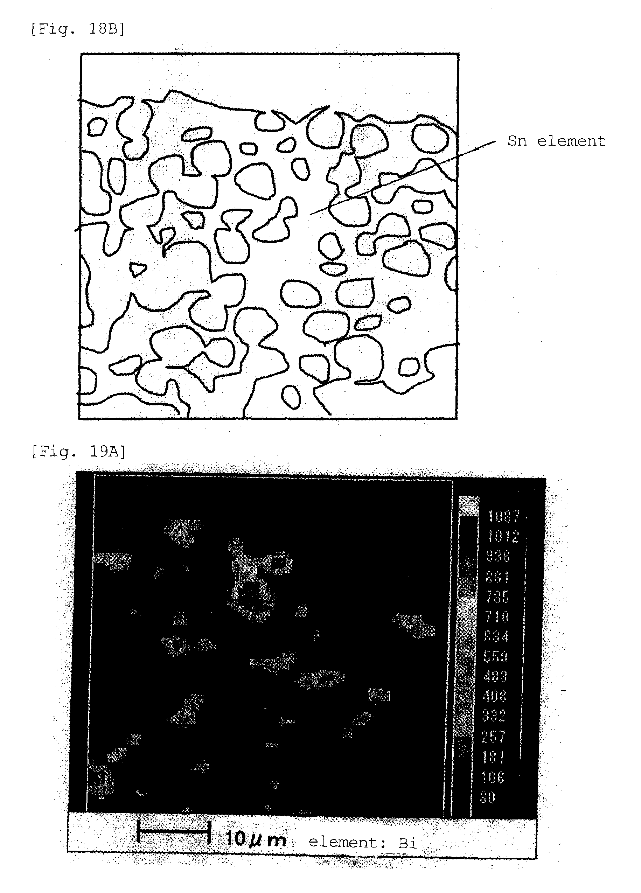

Figs. 18A and 18B are an image and its tracing, respectively, of an elemental map of Sn in the SEM image of Fig. 16A analyzed with EPMA.

From Figs. 18A and 18B, it is evident that on the surface of the plane-to-plane contact portions where the Cu particles are in plane-to-plane contact with one another, the second metal region is formed in a manner such that it extends astride the portion.

In Fig. 18B, most of the Cu particle surface appears to be covered with the second metal region. However, in EPMA, the epoxy resin becomes transparent, thereby causing the Sn element, not only on the observed surface, but also on the opposing surface, to be detected. Therefore, the second metal region does not cover most of the Cu particle surface, but in fact, is present on the Cu particle surface. This is also evident from the SEM images of Figs. 14A to 16A. Also, according to such a structure, force that develops in the relatively hard second metal regions, is absorbed by the softer Cu particles. Thus, cracks created in the second metal regions are prevented from spreading.

Figs. 19A and 19B are an image and its tracing, respectively, of an elemental map of Bi in the SEM image of Fig. 16A analyzed with EPMA.

From Fig. 19B, it is evident that Bi is present so that the third metal regions do not come into contact with the Cu particles. From the above, it is evident that Bi, having high resistance, does not affect the conductive path formed by contact produced among the Cu particles.

### [Example 2]

Next, the Cu particles and the Sn-Bi solder particles were checked in terms of particle size. Specifically, except for blending the Cu particles and the Sn42-Bi58 solder particles respectively having the average particle sizes listed in Table 2, Pastes No. 13 to 23 were prepared by blending the Cu particles and the Sn-Bi solder particles at a ratio of 60:40 as with Paste No. 6 in Example 1. Then, as in Example 1, a multilayer wiring board was obtained, followed by evaluations of initial resistance and connection reliability For connection reliability the via-hole conductors with 10% or lower percent of change from the initial resistance was evaluated as "A", those exceeding 10% was evaluated as "B", and those exceeding 30% was evaluated as "C".

**[Table 2]**

| Paste No. | 13 | 14 | 15 | 6 | 16 | 17 | 18 | 19 | 20 | 21 | 22 | 23 |
|---|---|---|---|---|---|---|---|---|---|---|---|---|
| average particle size of Cu particles (µm) | 20 | 10 | 7 | 5 | 20 | 10 | 7 | 5 | 10 | 5 | 3 | 3 |
| average particle size of Sn42-58Bi particles (µm) | 20 | 10 | 7 | 5 | 10 | 5 | 3 | 3 | 20 | 10 | 7 | 5 |
| Cu/Sn | 3.57 | 3.57 | 3.57 | 3.57 | 3.57 | 3.57 | 3.57 | 3.57 | 3.57 | 3.57 | 3.57 | 3.57 |
| initial resistance | C | B | B | A | B | B | A | A | C | C | C | C |
| connection reliability | C | C | C | A | B | B | A | A | C | C | C | C |

From Table 2, it is preferable that the Cu particles and the Sn-Bi solder particles have an average particle size of 5 µm or smaller, if they are to have the same average particle size. This is because, when the average particle size exceeds 5 µm, there would be difficulty in forming the plane-to-plane contact portions due to the Sn-Bi solder particles becoming interposed between the Cu particles. Also, as shown in Table 2 under Pastes No. 20 to 23, in instances where the Cu particles and the Sn-Bi solder particles differ in particle size, when the Sn-Bi solder particles are larger than the Cu particles in average particle size, it is not possible to obtain favorable results in both initial resistance and reliability This is presumed to be due to the Sn-Bi solder particles becoming included in the conductive path formed during pressurization. On the other hand, as shown in Table 2 under Pastes No. 6 and 16 to 19, when the Sn-Bi solder particles are smaller than the Cu particles in average particle size, it is possible to obtain favorable results in both initial resistance and reliability This is presumably due to a conductive path with a smaller electrical resistance being formed, due to the Sn-Bi solder particles being smaller than the Cu particles, thus enabling the Cu particles to be the first to come into contact with one another during pressurization, such that the plane-to-plane contact portions are easily formed; and causing difficulty for the Sn-Bi solder particles to come into contact with the Cu particles.

### [Comparison with Prior Art]

Next, a description will be given on the results obtained from a comparison made among the resistance of the via-hole conductor for a multilayer wiring board, described above in the Example; and the resistances of different kinds of via-hole conductors according to Patent Literature 4, also described above.

Fig. 20 is a graph showing a comparison of resistance values between a via-hole conductor for a multilayer wiring board, according to the Example; and the different kinds of via-hole conductors for a multilayer wiring board, according to Patent Literature 4.
In Fig. 20, the horizontal axis (X-axis) represents the Bi content in the via-hole conductor, expressed by mass%; and the vertical axis (Y-axis) represents the resistance value of the via-hole conductor, expressed by a relative value ("1" being the relative value of the lowest resistance value).
Line I in Fig. 20 shows the change in the relative resistance values, which are the results of [Table 1] in Example 1.
On the other hand, line II in Fig. 20 shows the change in the relative resistance values in the case of "Sn-2Ag-0.5Cu-20Bi" listed in Table 1 of Patent Literature 4. Also, line III in Fig. 20 shows the change in the relative resistance values in the case of "Sn-2Ag-0.5Cu-15Bi" listed in Table 1 of Patent Literature 4. Also, line IV in Fig. 20 shows the change in the relative resistance values in the case of "Sn-58Bi" listed in Table 1 of Patent Literature 4.

It is evident from Fig. 20 that, in the case of the via-hole conductor as shown by line I, that is, the via-hole conductor for a multilayer wiring board according to the Example, there is almost no increase in resistance of the via-hole conductor, even when the Bi content in the via-hole conductor increases. This is due to the fact that, in the via-hole conductor for a multilayer wiring board according to the Example, the copper particles come directly into plane-to-plane contact with one another, thereby forming the links made from the copper particles; and the links electrically connect the wirings to one another. Therefore, there is almost no increase in the resistance value, even when the Bi content increases.

On the other hand, in the case of the via-hole conductors shown by lines II, III, and IV, respectively, that is, the via-hole conductors for a multilayer wiring board listed in Table 1 of Patent Literature 4, it is evident that the resistance of the via-hole conductor rapidly increases, as the Bi content in the via-hole conductor increases. This is presumed to be due to the fact that, in the different kinds of the via-hole conductors according to Patent Literature 4, copper particles are electrically connected to one another with a high-resistance metal component interposed therebeween. This is presumed to be due to "a melted metal component taking part in the connection" as described in paragraph 0015 of Patent Literature 4. That is, it is presumed to be due to the high-resistance metal component between the copper particles becoming thicker, as the bismuth content increases.

As such, in the case of the via-hole conductor for a multilayer wiring board according to the Example, low resistance is maintained, since there is almost no rapid increase in the resistance of the via-hole conductor even when the bismuth content in the via-hole conductor increases. This is due to the copper particles forming the links by coming into contact with one another via the plane-to-plane contact portions; and the links electrically connecting the wirings to one another.

### [Industrial Applicability]

According to the present invention, it is possible to further reduce the cost and size, and to further enhance functionality and reliability, of multilayer wiring boards for use in, for example, cell phones. Also, in terms of via pastes, proposing a via paste most appropriate for producing a via paste reaction-induced material in via-hole conductors with a smaller diameter, would contribute to size reduction and reliability enhancement of multilayer wiring boards.

### [Explanation of Reference Numerals]

- 4: intermetallic compound
- 5, 24: void or crack
- 7: copper particle
- 11, 111: multilayer wiring board
- 12 (12a, 12b), 42: wiring
- 13, 113: insulating resin layer
- 125: prepreg
- 113a: resin sheet
- 13a: heat-resistant resin sheet
- 13b: cured resin layervia-hole conductor
- 14: metal portion
- 15: resin portion
- 16: first metal region
- 17a: link of Cu particles
- 17: second metal region
- 18: third metal region
- 19: plane-to-plane contact portion
- 20: virtual spring
- 21: fourth metal region
- 25: resin sheet
- 25a: uncured resin layer
- 26: protective film
- 27: through-hole
- 28: via paste
- 29: protrusion
- 30: copper foil
- 31: Sn-Bi solder particle
- 32: curable resin component
- 41: wiring board

## Claims

1. A wiring board comprising:
at least one insulating resin layer;
a first wiring disposed on a first surface of the insulating resin layer;
a second wiring disposed on a second surface of the insulating resin layer; and
via-hole conductors provided in a manner such that they penetrate through the insulating resin layer and electrically connect the first wiring and the second wiring,
wherein the via-hole conductor comprises a metal portion and a resin portion,
the metal portion comprising:
a first metal region including a link of copper particles which serves as a path for electrically connecting the first wiring and the second wiring;
a second metal region mainly composed of at least one metal selected from the group consisting of tin, a tin-copper alloy, and a tin-copper intermetallic compound;
a third metal region mainly composed of bismuth and in contact with the second metal region; and
a fourth metal region composed of tin-bismuth solder particles,
the copper particles forming the link are in plane-to-plane contact with one another, thereby forming plane-to-plane contact portions,
at least a part of the second metal region is in contact with the first metal region, and
the tin-bismuth solder particles, each surrounded by the resin portion, are interspersed in the via-hole conductor.

2. The wiring board in accordance with claim 1, wherein at least a part of the second metal region is in contact with the plane-to-plane contact portion of the link, in a manner such that it covers around the plane-to-plane contact portion.

3. The wiring board in accordance with claim 1 or 2, wherein the content of the copper particles in the via-hole conductor is in the range of 30 to 90 mass%.

4. The wiring board in accordance with any one of claims 1 to 3, wherein the average particle size of the tin-bismuth solder particles is equal to or smaller than the average particle size of the copper particles.

5. A method for producing a wiring board, the method comprising:
a first step of covering a surface of an insulating resin sheet with a protective film;
a second step of perforating the insulating resin sheet having the protective film thereon, so as to create through-holes;
a third step of filling the through-holes with a via paste containing copper particles, tin-bismuth solder particles, and a thermally curable resin, in which the content of the copper particles is in the range of 30 to 90 mass%; and the weight ratio between copper (Cu) of the copper particles and tin (Sn) of the tin-bismuth solder particles, represented by Cu/Sn, is in the range of 1.59 to 21.43;
a fourth step of removing the protective film after the third step to reveal protrusions each formed by a part of the via paste protruding from the through-hole;
a fifth step of disposing metal foil on at least one surface of the insulating resin sheet in a manner such that it covers the protrusions;
a sixth step of compression bonding the metal foil onto the at least one surface of the insulating resin sheet, and compressing, at a temperature lower than the eutectic temperature of the tin-bismuth solder particles, the via paste by way of the protrusions, so as to form a link of the copper particles, the link having plane-to-plane contact portions where the copper particles are in plane-to-plane contact with one another; and
a seventh step of heating after the sixth step, the via paste at a temperature higher than the eutectic temperature of the tin-bismuth solder particles,
wherein, in the sixth and seventh steps, a part of the tin-bismuth solder particles each surrounded by the resin portion, are interspersed in the via-hole conductor.

6. The method for producing a wiring board in accordance with claim 5, wherein the insulating resin sheet is an sheet including an uncured resin layer, that is, a heat-resistant sheet with an uncured resin layer on a surface thereof.

7. A via paste used for forming the wiring board in accordance with claim 1, the via paste comprising copper particles, tin-bismuth solder particles, and a thermally curable resin,
wherein the content of the copper particles is in the range of 30 to 90 mass%, and
the weight ratio between copper (Cu) of the copper particles and tin (Sn) of the tin-bismuth solder particles, represented by Cu/Sn, is in the range of 1.59 to 21.43.

8. The via paste in accordance with claim 7, wherein the maximum diameter of the via-hole conductor is in the range of 30 to 150 µm; and the average particle size of the copper particles is in the range of 3 to 10 µm.

9. The via paste in accordance with claim 7 or 8, wherein the tin-bismuth solder particles include particles having an average particle size equal to or smaller than that of the copper particles.

10. The via paste in accordance with any one of claims 7 to 9, wherein the content of the copper particles, relative to the total of the copper particles and the tin-bismuth solder particles, is 40 to 90 mass%.

11. The via paste in accordance with any one of claims 7 to 10, wherein the thermally curable resin is an epoxy resin.

12. The via paste in accordance with claim 11, wherein the epoxy resin contains a curing agent which is an amine compound having at least one hydroxyl group in its molecule.

13. The via paste in accordance with claim 12, wherein the boiling point of the amine compound is in a range from the eutectic temperature of the Sn-Bi solder particles, to 300°C.
